# EUROPEAN PATENT SPECIFICATION

(11) **EP 4 560 340 B1**
(45) Date of publication and mention of the grant of the patent: **26.08.2026**
(21) Application number: 23383207.0
(22) Date of filing: 24.11.2023
(51) Int. Cl.: G01R 33/32, G01N 24/00, G07D 7/12

(54) **METHOD AND SYSTEM FOR GENERATING A TAG FROM A CRYSTALLINE STRUCTURE**
VERFAHREN UND SYSTEM ZUR ERZEUGUNG EINES ETIKETTS AUS EINER KRISTALLINEN STRUKTUR
PROCÉDÉ ET SYSTÈME DE GÉNÉRATION D'UNE ÉTIQUETTE À PARTIR D'UNE STRUCTURE CRISTALLINE

(43) Date of publication of application: 28.05.2025
(73) Proprietor: Fundación Tecnalia Research & Innovation, 20009 San Sebastián, Guipúzcoa (ES); Universidad del Pais Vasco - Euskal Herriko Unibertsitatea (UPV/EHU), 48940 Leioa (ES)
(72) Inventor: GARROTE CONTRERAS, Estivaliz, San Sebastián - Guipúzcoa (ES); TERRADILLOS FERNÁNDEZ, Elena, San Sebastián - Guipúzcoa (ES); GONZÁLEZ RODRÍGUEZ, Marta, San Sebastián - Guipúzcoa (ES); VIDAL ASENSIO, Xavier, San Sebastián - Guipúzcoa (ES); ÁLVAREZ GILA, Aitor, San Sebastián - Guipúzcoa (ES); CASANOVA MARCOS, Jorge, Leioa (ES); MUNUERA JAVALOY, Carlos, Leioa (ES); TOBALINA NOVO, Ander, Leioa (ES); VARONA URIARTE, Borja, Leioa (ES)
(74) Representative: Balder IP Law, S.L.

(56) References cited:
- WO-A1-2021/092121
- RU-C1- 2 577 224
- BENJAMIN SMELTZER: "13 C hyperfine interactions in the nitrogen-vacancy centre in diamond", NEW JOURNAL OF PHYSICS, vol. 13, no. 2, 21 February 2011 (2011-02-21), GB, pages 025021, XP093158941, ISSN: 1367-2630, DOI: 10.1088/1367-2630/13/2/025021
- BORUAH ANUSUYA ET AL: "Synthesis, Characterization, Properties, and Novel Applications of Fluorescent Nanodiamonds", JOURNAL OF FLUORESCENCE, SPRINGER US, NEW YORK, vol. 32, no. 3, 1 March 2022 (2022-03-01), pages 863 - 885, XP037840084, ISSN: 1053-0509, [retrieved on 20220301], DOI: 10.1007/S10895-022-02898-2
- PENGCHENG FAN: "Detection of single 13 C spins coupled to NV center via dynamical decoupling design", JOURNAL OF PHYSICS D: APPLIED PHYSICS, vol. 55, no. 1, 6 October 2021 (2021-10-06), Bristol, GB, pages 015301, XP093158954, ISSN: 0022-3727, Retrieved from the Internet <URL:https://iopscience.iop.org/article/10.1088/1361-6463/ac27d6/pdf> [retrieved on 20240503], DOI: 10.1088/1361-6463/ac27d6

## Description

### TECHNICAL FIELD

The present disclosure pertains to the technical field of quantum technologies. In particular, the disclosure presents a system for obtaining an atomic signature from a crystalline structure, the crystalline structure comprising a plurality of defect color centers and their surrounding non-zero spin elements. A corresponding method and a computer program product are also provided. This disclosure also provides a method for obtaining a tag based on the atomic signature of the crystalline structure. This disclosure further provides the use of a unique tag from the crystalline structure in digital identification, authentication, tracking and transactions registry or database applications, for example in a blockchain application.

### BACKGROUND OF THE INVENTION

The current use of optically readable labels or tags, for example in the form of QR (Quick Response) codes, bar codes, holograms or RFID (Radio Frequency Identification) chips, that encode information associated with an object to which the tag is attached, may provide different levels of security during the authentication or identification of the object.

Tags relying on optically readable components may be tailored to exploit the quantum properties of a crystalline structure that has a characteristic optical response to an excitation.

Some tags that are optically analyzed have been proposed, which incorporate the use of defect color centers orientation in a crystalline structure. The crystalline structure, for example, includes a diamond crystal and a prominent example of defect color centers in diamond consists of nitrogen vacancy (NV) centers. The term NV corresponds to the negatively charged nitrogen-vacancy center.

Defect color centers are defects that appear naturally or can be artificially created in the crystalline structure. For example, in a diamond crystal, an NV center consists of a substitutional nitrogen atom and an adjacent vacant site.

Notably, an NV center has optical properties that allow the coupling and manipulation of spin degrees of freedom with light. For example, the electron spin states of the NV center can be polarized by exciting the NV centers with green light. Further, spin state transitions of NV centers can be characterized by optically detected magnetic resonance. For example, after applying an off-resonance green laser and further manipulating with microwave (MW) fields, optical transitions become accessible, which are closely linked with the spin degrees of freedom. The electron spin states, hence, can be measured, for example, through the photoluminescence (PL) emitted by the NV center in a spectral range of *λ*=630-800 nm.

RU2577224 C1 discloses a method of producing two types of an active substance of a label for counterfeit-protection of articles, containing diamond microcrystals with active NV centres.

Current tags based on the optical response of a crystalline structure (in the form of, for example, PL measurements) rely on orientation information extracted from the defect color centers. These tags, nevertheless, do not include distribution of the atoms surrounding each NV center, which naturally and randomly occurs in diamond crystals. Moreover, the optical response is obtained from all the defect color centers collectively by using conventional optical microscopy. For instance, WO 2021/092121 A1 discloses extracting spatial orientation information from a NV center. A unique code for an object associated to the orientation of the NV distribution can be generated by identifying a plurality of NV centers.

Current tags based on NV centers, nevertheless, do not include the distribution of the non-zero spin elements surrounding each NV center, which naturally occurs in diamond crystals. For example, in the case of crystalline diamond, which is predominately formed by Carbon-12, the non-zero spin elements of an NV center are formed, among others, by a plurality of magnetically active Carbon-13 nuclei surrounding the NV center.

The ability to generate a tag from a crystalline structure based on individual defect color centers and their local magnetic environment that offers a high level of security when retrieving information from the crystal and from the object, or from the object, to which the tag is attached is therefore of paramount importance as it cannot be either modified or created following a predefined distribution.

### SUMMARY OF THE INVENTION

In view of the above, this disclosure aims to provide a method and system for obtaining a tag associated to a crystalline structure based on individual defect color centers of the structure and local non-zero spin atomic distribution of each defect color center. The tag is based on an atomic signature of the structure. The atomic signature is associated to defect color centers, such as obtained from individual atoms (i.e. non-zero spin nuclei) surrounding one or more defect color centers of the structure. Therefore, the tag is based on the influence caused on a defect color center by non-zero spin nuclei surrounding the defect color center. The ability to generate a tag based on an atomic signature of a crystalline structure offers a high level of security when retrieving information from the crystal and from the object, or from the object, to which the tag is attached as it cannot be either modified or created following a predefined distribution.

This disclosure also aims to provide a method and system for determining an atomic signature of a crystalline structure comprising at least one defect color center and a plurality of non-zero spin nuclei in the vicinity of each defect color center.

Remarkably, atomic-scale imperfections, even down to single-atom defects, associated with the crystal growth or fabrication process can be used as a fingerprint that is challenging to reproduce.

An objective is to determine the atomic signature of a crystalline structure, for example to subsequently obtain a unique tag associated with this signature, or to implement quantum devices, such as a quantum memory or a quantum computer, or for any application requiring crystal characterization, such as automatic characterization of hyperfine coupling parameters. The atomic signature is based on the response of individual defect color centers to external excitations. This response in turn depends on changes in the readout signal corresponding to each (in general, at least one) non-zero spin element (i.e. nucleus) around each defect color center. The local non-zero spin atomic distribution of a defect color center, which refers to the magnetic moment from non-zero spins that due to the proximity and energy strength can alter (be sensed, coupled) by the defect color center magnetic moment, comprises at least one non-zero spin nuclei surrounding the defect color center.

Another objective is to use the unique tag in digital authentication, identification, tracking and transactions registry applications.

From the obtained response associated to one or more individual defect color centers of the structure, an atomic signature of the crystalline structure is determined. This atomic signature represents changes in the local non- zero spin atomic distribution of the at least one defect color center. The local non- zero spin atomic distribution of each defect color center is typically formed by a plurality of non-zero spin nuclei surrounding the corresponding defect color center. In particular, the spatial distribution of non-zero spin nuclei in the vicinity of a defect color center provide an extraordinary means to uniquely identify the crystalline structure with extremely high level of security. The response of one or more defect color centers of a crystalline structure is used as a means to identify the non-zero spin nuclei surrounding each defect color center. For example, the response is used to obtain the relative spatial position of each non-zero spin nuclei with respect to the defect color center to which the nuclei are associated. This information (for example the relative spatial position of the nuclei) forms the atomic signature of the structure.

The objectives are achieved by the solution provided in the appended independent claims. Advantageous implementations are further defined in the dependent claims.

In embodiments of this disclosure, the crystalline structure can be solid state spins crystal, such as but not limited to diamond crystal or silicon carbide (SiC).

Crystalline diamond is predominately formed by Carbon-12, which is the most abundant carbon-isotope in Nature and is magnetically neutral; however, it also contains non-zero spin nuclei. For example, it contains Carbon-13 (hereinafter 13C), which is a magnetically active isotope, more specifically it is a spin-1/2 particle. The percentage of 13C atoms in diamond with respect to their magnetically neutral counterpart is around 1.1% in natural abundance. Hence, considering the 1.1% 13C abundance and that the average distance between crystal sites in diamond is around 1.54 x 10⁻⁸ cm, for a diamond sample with a volume of 1 cm³ there is of the order of 10²¹ 13C atoms randomly distributed in the crystal. Moreover, synthetic diamond can be formed using a different controlled abundance of C isotopes, adding another level of control in the average distance and number of 13C around a color center. These values indicate that the position of 13C isotopes within the diamond crystal of a particular diamond structure makes it completely unique.

A prominent example of defect color centers in diamond are NV centers. An NV center is a substitutional nitrogen atom and an adjacent vacant site. The local magnetic environment of each NV center is formed by a plurality of non-zero spin nuclei (also referred to as nuclear spins) surrounding the corresponding NV center. For example, each NV center is surrounded by a plurality of Carbon-13 nuclei. Thus, the local non-zero spin atomic distribution corresponding to each of the NV centers may comprise a plurality of magnetically active 13C nuclei surrounding the corresponding NV center in the diamond crystal.

In this disclosure, the terms 13C atom and 13C nucleus are used interchangeably.

Other non-zero spin nuclei surrounding a NV center are nitrogen not forming NV-centers in the form of 14N or 15N as well as, for example, hydrogen or fluor spins just to mention different possibilities.

Other suitable crystalline structures include a silicon carbide (SiC) material. In this case, defect color centers can be silicon vacancy (V_{Si}) defects. The SiC material may comprise non-zero spin nuclei, such as magnetically active 13C nuclei. In addition, the SiC material may also comprise 29Si stable isotopes, each having a spin-1/2. Thus, the local non-zero spin atomic distribution corresponding to each V_{Si} defect in SiC may comprise a plurality of magnetically active 13C nuclei and/or magnetically active 29Si nuclei surrounding the corresponding V_{Si} defect in the SiC material.

As already mentioned, a tag associated to the atomic signature of a crystalline structure is generated. The atomic signature, and therefore generated tag, are based on the enhanced sensitivity (due to quantum properties of the defect color center) of individual defect color centers to the non-zero spin nuclei surrounding each defect color center. The atomic signature comprises information about the local atomic distribution surrounding one or more defect color centers. For example, this information can be the relative position of the non-zero spin nuclei of a defect color center with respect to the defect color center, or this information can be the hyperfine frequency parameters of the non-zero spin nuclei.

The influence of the non-zero spin nuclei surrounding a defect color center can be measured through the change in the magnetic field caused by the nuclei, effect that is dependent on the relative position with respect to the center.

With further detail, in the context of the present disclosure, a defect color center can be understood as a two-level system where the two levels ("0" and "-1" or "0" and "+1") are separated by a certain energy value in a frequency within the Gigahertz spectrum. Each non-zero spin nucleus (nuclear spin) modifies the magnetic field of a determined defect color center. Usually, the two levels are separated by a certain energy value in a frequency within the Kilohertz or Megahertz spectrum. The exact frequency value depends, among others, on the type of nuclei (Hydrogen, Carbon, Fluor, etc.) and, if applicable, on an external magnetic field applied. Because the energy of the defect color center is associated to a frequency very far from the frequency to which the energy of a non-zero spin nucleus surrounding the defect color center is associated, there is a huge energy-gap that prevents the communication (or coupling) between the defect color center and the nuclear spin(s). For example, in the case of a diamond crystal, the electron spin of an NV center couples to each 13C nucleus present in the diamond through dipolar coupling denoted by a coupling constant *̅A̅*̅. By characterizing these couplings between an NV center (which acts as a sensor) and its nuclei, an entire qubit system can be characterized since both the sensor (NV center) and the non-zero spin nuclei act as two-level systems.

The energy associated to each non-zero spin nucleus and nearby certain defect color center depends on the relative position between each nucleus and the defect color center. Thus, the energy gap in a pair "nucleus-defect color center" is in general different from the energy gap in any other pair of "nucleus-defect color center". This gap and therefore the relative position of the nucleus to the color center can be represented by the coupling constant *̅A̅*̅, also referred to as hyperfine parameters of each nucleus. The hyperfine parameters are coupling parameters between the electronic spin of a defect color center and the nuclear spins of each non-zero spin nucleus (such as 13C). The coupling constant *̅A̅*̅ has two components: a component parallel to an axis (typically Z-axis) of the defect color center (A^{par}) and a component perpendicular to that axis (A^{perp}). Therefore, the energy of each nucleus nearby a certain defect color center depends on their hyperfine parameters. The influence or print of each nucleus on the defect color center can be seen as an energy gap (added to the energy gap derived from the sublevels +1, -1, 0). The atomic signature to be determined represents this additional energy gap caused by each nucleus on the defect color center. This means that the hyperfine frequency parameters of the non-zero spin nuclei that can form the atomic signature of the structure represent the additional energy gap caused by each nucleus on the defect color center because the gap energy is directly related to the frequency.

To determine the atomic signature of a crystalline structure it is necessary that each defect color center exchanges excitation (communicates, or couples) with each of the nuclei around it. This excitation is enabled when a microwave (MW) sequence (in the order of Gigahertz, such as between 0.3 and 30 GHz) is applied. An external magnetic field can also be required in certain circumstances. Then, after applying an optical radiation, optical transitions become accessible, which are closely linked with the spin degrees of freedom. The electron spin states, hence, can be measured, for example, through the photoluminescence (PL) emitted by the NV center in a certain spectral range or through photocurrent detection. The reflected spectrum (signal) that depends on the number and position of nuclei nearby a certain center is used to determine the atomic signature.

To obtain a signal representing the reaction of each defect color center to the applied MW radiation, this reaction in turn depending on the number and position of the nuclei surrounding the defect color center, an optical radiation emitted with an optical source, such as a laser source, in a wavelength range capable of optically exciting the color defect center is applied. The wavelength range of the applied laser source depends, among others, on the type of defect color center of interest. For example, when the defect color center is an NV center, a laser source varying between 610 and 665 nm can be used. This permits to read an emitted response (such as a fluorescence response or a photocurrent response) and thus infer whether or not the MW radiation has caused the mentioned coupling between a nucleus and a defect color center. When a MW radiation sequence is applied, and in certain circumstances also a magnetic field, to the crystalline structure, so that at least one individual defect color center of the structure is coupled to at least some of the nuclei forming the local magnetic environments of the at least one center, a signal comprising (i.e. encoding) information related to the coupling (dipolar coupling *̅A̅*̅) established between a defect color center (for example, an NV center) and at least some of the nuclei (for example, 13C nuclei) forming the local non-zero spin atomic distribution of that center, is obtained. This signal is for example a fluorescence signal that can be captured with an optical device. This signal, which provides information related to the coupling between a center and a nucleus, depends on the relative position of the nuclei with respect to the center. The atomic signature is determined from this signal.

However, it is not trivial to decode the information of this signal to determine an atomic signature of the crystalline structure. These signals, whose variations are associated to quantum randomness and interference due to the effect of different nuclei, are characterized by being very weak, i.e. of low intensity, and narrow, and at the same time having a strong noise component. In the present disclosure, information about the nuclear spins, namely their relative position with respect to the defect color center present in the crystalline structure are extracted or identified from the captured signals using an artificial intelligence model. This model harnesses the information encoded in the signals to extract, for example, the relative spatial position (XYZ) of the nuclei with respect to the defect color center or the hyperfine coupling parameters (dipolar coupling constant *̅A̅*̅) between a nucleus and a defect color center.

In sum, each defect color center acts as a sensor that is sensitive to the surrounding nuclei (or at least to some surrounding non-zero spin nuclei). This sensitivity is reflected in the collected signal(s). In other words, each defect color center acts as a sensor capable of interrogating or listening to the information provided by its nearby coupled nucleus.

A tag can then be generated from the determined atomic signature of the crystalline structure. A first aspect of the invention provides a method for generating a tag from a crystalline structure comprising at least one defect color center and a plurality of non-zero spin nuclei in the vicinity of each defect color center, the method comprising:
applying at least one microwave field sequence to the crystalline structure;
applying an optical radiation to the crystalline structure to excite at least one defect color center;
detecting, for at least one defect color center and at least one nuclei of the plurality of non-zero spin nuclei located in the vicinity thereof, a response of the crystalline structure;
from the detected response, determining, by a processor, an atomic signature of the crystalline structure, said atomic signature comprising information of the non-zero spin nuclei distribution of the at least one defect color center, wherein said information is the relative position XYZ of the at least one non-zero spin nucleus with respect to the corresponding defect color center;
generating, by the processor, a unique tag based on the atomic signature.

This provides with a unique and non-reproducible tag associated with the crystalline structure, which is based on the unique response of individual defect color centers as a consequence of the distribution of the atoms surrounding each defect color center. Owing to the fact that the number and position of the plurality of defect color centers in a crystal are nearly impossible to reproduce, the generated tag defines a unique and non-reproducible fingerprint of the crystalline structure that takes into account the effect of the magnetic environment surrounding each defect color center, which is inherent to the crystal.

The physical substrate of the tag is the crystalline structure from which the atomic signature has been determined.

Further advantageously, unlike in prior art proposals, the method may enable a fast detection and control of the response of the crystalline structure without the need for magnetic field reorientation, which is time-consuming in current laboratory setups and which further affects the fluorescence properties of defect color centers.

In an implementation form of the first aspect, a magnetic field is also applied to the crystalline structure, to enable that at least one individual defect color center of the structure is coupled to at least one of the nuclei forming the local non-zero spin atomic distribution of the at least one center. The application of an external magnetic field is necessary when, in the absence of magnetic field, the spin sub-states are degenerated. In this case, the external magnetic field separates the superposition of the different magnetic moments associated to the spin and facilitates to find the frequency coupling. The applied magnetic field can also contribute to prevent spin-flipping.

In an implementation form of the first aspect, the response of the crystalline structure to the applied optical radiation is an optical response, such as a fluorescence response, captured with an optical device. In this implementation, an optical device is used to detect an optical response (such as fluorescence) of the crystalline structure. The optical device is designed to detect an optical signal from the at least one defect color center. Non-limiting examples of optical devices that can be used, are: a fluorescence microscope, a confocal microscope, a super-resolution imaging device and fiber coupled detectors. In implementations in which more than one defect color center is to be detected individually, the optical device must have spatial resolution to detect the individual response of different defect color centers.

In an alternative implementation form of the first aspect, the response of the crystalline structure to the applied optical radiation is a photoelectric response of the electron-spin resonance of at least one defect color center, captured with an electronic device. An electronic device including electrodes can be used. In implementations in which more than one defect color center is to be detected individually, the excitation source must have enough spatial resolution to excite a single defect color center.

In an implementation form of the first aspect, the information of the at least one non-zero spin nucleus of the at least one defect color center comprised in the atomic signature represents at least one property of the local non-zero spin atomic distribution corresponding to the at least one defect color center, the at least one property comprises at least one of hyperfine coupling parameters corresponding to the coupling of at least one defect color center and each non-zero spin nuclei, and a relative position of the non-zero spin atomic distribution corresponding to each of the defect color centers. In other words, the atomic signature characterizes the non-zero spin nuclei of the at least one defect color center.

This provides the advantage that the at least one property of the non-zero spin atomic distribution corresponding to each defect color center can be easily extracted from the spectrum, such as photoluminescence spectrum, emitted by the defect color center.

In an implementation form of the first aspect, when the response is an optical response, the optical response of the crystalline structure comprises a photoluminescence spectrum emitted by each of the defect color centers, wherein the photoluminescence spectrum depends on the at least one property of the non-zero spin atomic distribution corresponding to each of the defect color centers.

This provides the advantage that the at least one property of the non-zero spin atomic distribution corresponding to each defect color center can be easily extracted from the photoluminescence spectrum emitted by the defect color center.

In an implementation form of the first aspect, the atomic signature of the crystalline structure comprises the hyperfine coupling parameters of the at least one non-zero spin nucleus of the at least one defect color center.

In an implementation form of the first aspect, the step of determining, by a processor, an atomic signature of the crystalline structure, involves that the information of the at least one non-zero spin nucleus of the at least one defect color center comprised in the atomic signature is extracted from the detected response using an artificial intelligence (AI) model.

In an implementation form of the first aspect, the at least one MW field sequence comprises a plurality of MW field sequences, and each of the plurality of MW field sequences are respectively different from each other.

In an implementation form of the first aspect, the method further comprises receiving, by a stage region, the crystalline structure, and continuously changing, by a stage controller, a position of the state region, so that a surface of the crystalline structure is scanned by a device to individually capture the readout of the one or more defect color centers.

This may provide with an automatic and precise positioning of the crystalline structure that is analyzed.

In an implementation form of the first aspect, the method further comprises performing the detection of the crystalline structure at one or more temperatures. The one or more temperatures comprise, for example, room temperature, lower temperatures than room temperature, up to ultralow temperatures, or higher temperatures than room temperature, such as above 100 °C. The response of each defect color center may vary with temperature. For example, the response of each defect color center at temperatures of the order of 4 K may be different than the optical response of the crystalline structure emitted at room temperature, and may encompass further details of the corresponding local non-zero spin atomic distribution. Accordingly, performing the detection of the response of each defect color center at different temperatures may provide with further levels of security offered by the unique tag.

In an implementation form of the first aspect, the method further comprises applying, by a RF controller, at least one RF field to the crystalline structure.

In an implementation form of the first aspect, method further comprises detecting, at several positions, the response of the crystalline structure to the at least one MW field sequence and to the applied at least one RF field.

The applied at least one RF field may break the symmetry of the arrangement formed by a defect color center and its corresponding local non-zero spin atomic distribution. This may result in a different signal emitted by each defect color center in response to each MW field sequence.

In an implementation form of the first aspect, the unique tag is generated based on the response to the local non-zero spin atomic distribution of a defect color center of the crystalline structure. Alternatively, the unique tag is generated based on the response of a plurality of defect color centers of the crystalline structure to their local non-zero spin atomic distribution.

In an implementation form of the first aspect, after generating a tag from the atomic signature of the structure, the method further comprises authenticating, by a processor, the crystalline structure based on the generated unique tag.

In an implementation form of the first aspect, the method further comprises determining, by a processor, a tag difference based on the generated unique tag for the crystalline structure and a reference tag for the crystalline structure, and determining that the crystalline structure is authentic when the tag difference is less than a pre-set threshold.

This provides the advantage that the quantum nature of the unique tag can be further exploited in order to authenticate the crystalline structure itself, additionally or alternatively to authenticate an object associated with the crystalline structure to which the tag is attached.

In an implementation form of the first aspect, the crystalline structure comprises a diamond crystal and the plurality of defect color centers comprises one or more of the following types of defect color centers: NV centers, SiV, GeV and tin-vacancies, among others. Alternatively, the crystalline structure comprises, for instance, a silicon carbide material and the plurality of defect color centers comprises silicon vacancy centers.

In an implementation form of the first aspect, the non-zero spin nuclei distribution corresponding to each of the defect color centers comprises a plurality of carbon of isotope 13 (13C) nuclei.

A second aspect of the invention provides a system for generating a tag from a crystalline structure comprising at least one defect color center and a plurality of non-zero spin nuclei in the vicinity of each defect color center. The system comprises:
a microwave source configured to apply at least one microwave field sequence to the crystalline structure;
a light source configured to apply an optical radiation to the crystalline structure to excite at least one defect color center;
a device configured to detect, for at least one defect color center and at least one nucleus of the plurality of non-zero spin nuclei located in the vicinity thereof, a response of the crystalline structure;
a processor configured to:
   from the detected response, determine an atomic signature of the crystalline structure, said atomic signature comprising information of the non-zero spin nuclei distribution of the at least one defect color center, wherein said information is the relative position XYZ of the at least one non-zero spin nucleus with respect to the corresponding defect color center,
   generate a unique tag based on the atomic signature.

In an implementation form of the second aspect, a magnetic field is also applied to the crystalline structure, for example by a magnet, to enable that at least one individual defect color center of the structure is coupled to at least some of the nuclei forming the local non-zero spin atomic distribution of the at least one center. The application of an external magnetic field is necessary when, in the absence of magnetic field, the spin sub-states are degenerated. In this case, the external magnetic field separates the superposition of the different magnetic moments associated to the spin and facilitates to find the frequency coupling. The applied magnetic field can also contribute to prevent spin-flipping.

In an implementation form of the second aspect, the optical device configured to apply an optical radiation to the crystalline structure to excite at least one defect color center is a laser source. The wavelength range at which the laser source operates depends, among others, on the type of defect color center to be excited. For example, when the defect color center is an NV center, a laser source whose emission varies between 610 and 665 nm can be used.

In an implementation form of the second aspect, the response of the crystalline structure to the applied optical radiation is an optical response. The system includes an optical device to capture the optical response (such as fluorescence) of the crystalline structure. An optical device capable of detecting an optical signal from the at least one defect color center is used. Non-limiting examples of optical devices that can be used, are: a fluorescence microscope, a confocal microscope, a super-resolution imaging device and fiber coupled detectors. In implementations in which more than one defect color center is to be detected individually, the optical device must have spatial resolution to detect the individual response of different defect color centers.

In an alternative implementation form of the second aspect, the response of the crystalline structure to the applied optical radiation is a photoelectric response of the electron-spin resonance of at least one defect color center. The system includes an electronic device to capture the photoelectric response of the crystalline structure. An electronic device including electrodes can be used. In implementations in which more than one defect color center is to be detected individually, the excitation source must have enough spatial resolution to excite a single defect color center.

In an implementation form of the second aspect, the information of the at least one non-zero spin nucleus of the at least one defect color center comprised in the atomic signature represents at least one property of the local non-zero spin atomic distribution corresponding to the at least one defect color center, the at least one property comprises at least one of hyperfine coupling parameters corresponding to the coupling of at least one defect color center and each non-zero spin nuclei, and a relative position of the non-zero spin atomic distribution corresponding to each of the defect color centers. In other words, the atomic signature characterizes the non-zero spin nuclei of the at least one defect color center.

In an implementation form of the second aspect, when the response is an optical response, the optical response of the crystalline structure comprises a photoluminescence spectrum emitted by each of the defect color centers, wherein the photoluminescence spectrum depends the on at least one property of the non-zero spin atomic distribution corresponding to each of the defect color centers.

In an implementation form of the second aspect, the atomic signature of the crystalline structure comprises the hyperfine coupling parameters of the at least one non-zero spin nucleus of the at least one defect color center.

In an implementation form of the second aspect, the information of the at least one non-zero spin nucleus of the at least one defect color center comprised in the atomic signature is extracted from the detected optical response using an artificial intelligence (AI) model.

The AI model extracts intrinsic information from the signals to characterize the non-zero spin atomic distribution, for example, the number of nuclei coupled to the defect color center sensor, as well as parameters defining the nuclei forming non-zero spin atomic distribution of the defect color center, such as the nuclei positions or the corresponding coupling constants (hyperfine parameters) between the sensor and each individual nucleus.

In an implementation form of the second aspect, the IA model is based on one or more of the following techniques: convolutional neural networks, architectures based on transformer or attention mechanism as transformer and recurrent neural networks, such as long-short term memory (LSTM). The one or more techniques may be combined with computer vision techniques.

In an implementation form of the second aspect, the microwave source is configured to apply a plurality of MW field sequences, and each of the plurality of MW field sequences are respectively different from each other.

In an implementation form of the second aspect, the system further comprises: a stage region configured to receive the crystalline structure; and a stage controller configured to continuously change a position of the state region, so that a surface of the crystalline structure is scanned by the detecting device.

In an implementation form of the second aspect, the detection device is configured to perform the detection of the response of the crystalline structure is done at one or more temperatures. The one or more temperatures comprise, for example, room temperature, lower temperatures than room temperature, up to ultralow temperatures, or higher temperatures than room temperature, such as above 100 °C.

Accordingly, performing the detection of the optical response of each defect color center at different temperatures may provide with further levels of security offered by the unique tag. In an implementation form of the second aspect, the system further comprises a RF controller configured to apply at least one RF field to the crystalline structure.

In an implementation form of the second aspect, the detection device is configured to detect, at several positions, the response of the crystalline structure to the at least one MW field sequence and to the applied at least one RF field.

In an implementation form of the second aspect, the unique tag is generated based on the response to the local non-zero spin atomic distribution of a defect color center of the crystalline structure. Alternatively, the unique tag is generated based on the response of a plurality of defect color centers of the crystalline structure to their local non-zero spin atomic distribution.

In an implementation form of the second aspect, a processor is further configured to authenticate the crystalline structure based on the generated unique tag.

In an implementation form of the second aspect, a processor is further configured to determine a tag difference based on the generated unique tag for the crystalline structure and a reference tag for the crystalline structure, and determine that the crystalline structure is authentic when the tag difference is less than a pre-set threshold.

In an implementation form of the second aspect, the crystalline structure comprises a diamond crystal and the plurality of defect color centers comprises one or more of the following types of defect color centers: NV centers, SiV, GeV and tin-vacancies, among others. Alternatively, the crystalline structure comprises, for instance, a silicon carbide material and the plurality of defect color centers comprises silicon vacancy centers.

In an implementation form of the second aspect, the non-zero spin nuclei distribution corresponding to each of the defect color centers comprises a plurality of carbon of isotope 13 (13C) nuclei.

The system of the second aspect can be further developed according to the foregoing implementation forms of the method of the second aspect. The system of the second aspect, thus, provides the same advantages as described above for the method of the first aspect and its respective implementation forms.

A third aspect of the invention provides a computer program product in accordance with claim 12.

The computer program product according to the third aspect comprises the features of the corresponding implementation forms of the method of the first aspect. Thus, the computer program product of the third aspect provides the same advantages as described above for the method of the first aspect and the system of the second aspect and their respective implementation forms.

A fourth aspect of the invention provides the use of a unique tag associated to a crystalline structure generated according to the method of the first aspect, for example in digital tracking and transactions registry or database, the digital tracking and transactions registry or database preferably comprising a block chain application.

This provides the advantage that the uniqueness of the generated tag can be further exploited in a blockchain process for registering an identifier associated with the unique tag in a decentralized network. This process does not reveal real user information, that is, it provides with pseudonymization of a user. Further, a digital tag based on the generated unique tag can be recorded, transferred and deleted by the blockchain process.

A fifth aspect of this disclosure provides a method for determining an atomic signature of a crystalline structure comprising a plurality of defect color centers and a plurality of non-zero spin nuclei in the vicinity of each defect color center, the method comprising:
applying at least one microwave field sequence to the crystalline structure;
applying an optical radiation to the crystalline structure to excite at least one defect color center;
detecting, for at least one defect color center and at least one nuclei of the plurality of non-zero spin nuclei located in the vicinity thereof, a response of the crystalline structure;
from the detected response, determining, by a processor, an atomic signature of the crystalline structure, said atomic signature comprising information of non-zero spin nuclei distribution of the at least one defect color center.

In an implementation form of the fifth aspect, a magnetic field is also applied to the crystalline structure, to enable that at least one individual defect color center of the structure is coupled to at least some of the nuclei forming the local non-zero spin atomic distribution of the at least one center. The application of an external magnetic field is necessary when, in the absence of magnetic field, the spin sub-states are degenerated. In this case, the external magnetic field separates the superposition of the different magnetic moments associated to the spin and facilitates to find the frequency coupling. The applied magnetic field can also contribute to prevent spin-flipping.

In an implementation form of the fifth aspect, the response of the crystalline structure to the applied optical radiation is an optical response captured with an optical device. In this implementation, an optical device is used to detect an optical response (such as fluorescence) of the crystalline structure. The optical device is designed to detect an optical signal from the at least one defect color center. Non-limiting examples of optical devices that can be used, are: a fluorescence microscope, a confocal microscope, a super-resolution imaging device and fiber coupled detectors. In implementations in which more than one defect color center is to be detected individually, the optical device must have spatial resolution to detect the individual response of different defect color centers.

In an alternative implementation form of the fifth aspect, the response of the crystalline structure to the applied optical radiation is a photoelectric response of the electron-spin resonance of at least one defect color center, captured with an electronic device. An electronic device including electrodes can be used. In implementations in which more than one defect color center is to be detected individually, the excitation source must have enough spatial resolution to excite a single defect color center.

In an implementation form of the fifth aspect, the information of the non-zero spin nuclei of the at least one defect color center comprised in the atomic signature represents at least one property of the local non-zero spin atomic distribution corresponding to the at least one defect color center, the at least one property comprises at least one of hyperfine coupling parameters corresponding to the coupling of at least one defect color center and each non-zero spin nuclei, and a relative position of the non-zero spin atomic distribution corresponding to each of the defect color centers. In other words, the atomic signature characterizes the non-zero spin nuclei of the at least one defect color center.

In an implementation form of the fifth aspect, when the response is an optical response, the optical response of the crystalline structure comprises a photoluminescence spectrum emitted by each of the defect color centers, wherein the photoluminescence spectrum depends the on at least one property of the non-zero spin atomic distribution corresponding to each of the defect color centers.

In an implementation form of the fifth aspect, the atomic signature of the crystalline structure comprises the hyperfine coupling parameters of the at least one non-zero spin nucleus of the at least one defect color center.

In an implementation form of the fifth aspect, the atomic signature of the crystalline structure comprises the relative position XYZ of the at least one non-zero spin nucleus of the at least one defect color center with respect to the corresponding defect color center.

In an implementation form of the fifth aspect, the step of determining, by a processor, an atomic signature of the crystalline structure, involves that the information of the non-zero spin nuclei of the at least one defect color center comprised in the atomic signature is extracted from the detected response using an artificial intelligence (AI) model.

The AI model extracts intrinsic information from the signals to characterize the non-zero spin atomic distribution, for example, the number of nuclei coupled to the defect color center sensor, as well as parameters defining the nuclei forming non-zero spin atomic distribution of the defect color center, such as the nuclei positions or the corresponding coupling constants (hyperfine parameters) between the sensor and each individual nucleus.

In an implementation form of the fifth aspect, the IA model is based on one or more of the following techniques: convolutional neural networks, architectures based on transformer or attention mechanism as transformer and recurrent neural networks, such as long-short term memory (LSTM). The one or more techniques may be combined with computer vision techniques.

In an implementation form of the fifth aspect, the at least one MW field sequence comprises a plurality of MW field sequences, and each of the plurality of MW field sequences are respectively different from each other.

In an implementation form of the fifth aspect, the method further comprises receiving, by a stage region, the crystalline structure, and continuously changing, by a stage controller, a position of the state region, so that a surface of the crystalline structure is scanned by a detection device to individually capture the readout of the one or more defect color centers.

This may provide with an automatic and precise positioning of the crystalline structure that is analyzed.

In an implementation form of the fifth aspect, the method further comprises performing the detection of the crystalline structure at one or more temperatures. The one or more temperatures comprise, for example, room temperature, lower temperatures than room temperature, up to ultralow temperatures, or higher temperatures than room temperature, such as above 100 °C.

In an implementation form of the fifth aspect, the method further comprises applying, by a RF controller, at least one RF field to the crystalline structure.

In an implementation form of the fifth aspect, method further comprises detecting, at several positions, the response of the crystalline structure to the at least one MW field sequence and to the applied at least one RF field.

In an implementation form of the fifth aspect, the crystalline structure comprises a diamond crystal and the plurality of defect color centers comprises one or more of the following types of defect color centers: NV centers, SiV, GeV and tin-vacancies, among others. Alternatively, the crystalline structure comprises, for instance, a silicon carbide material and the plurality of defect color centers comprises silicon vacancy centers.

In an implementation form of the fifth aspect, the non-zero spin nuclei distribution corresponding to each of the defect color centers comprises a plurality of carbon of isotope 13 (13C) nuclei. A sixth aspect of this disclosure provides the use of an atomic signature determined according to the method of the fifth aspect, to implement quantum devices, such as a quantum memory or a quantum computer.

A seventh aspect of this disclosure provides a computer program product comprising a program code for carrying out, when implemented on a processor, the method according to the fifth aspect. In any of the aspects of the invention, the AI model extracts intrinsic information from the signals to characterize the non-zero spin atomic distribution, for example, the number of nuclei coupled to the defect color center sensor, as well as parameters defining the nuclei forming non-zero spin atomic distribution of the defect color center, such as the nuclei positions or the corresponding coupling constants (hyperfine parameters) between the sensor and each individual nucleus.

In an implementation form of any of these aspects, the IA model is based on one or more of the following techniques: convolutional neural networks, architectures based on transformer or attention mechanism as transformer and recurrent neural networks, such as long-short term memory (LSTM). The one or more techniques may be combined with computer vision techniques. This post-processing stage (computer vision-based) permits to extract valuable information from the output of the IA model as such (i.e. neural network).

In an implementation form of any of these aspects, the IA model uses as input a single signal corresponding to a MW sequence. In other implementations of the first aspect, the IA model uses as input two or more signal corresponding to a corresponding number of MW sequences with different number of pulses. For example, the IA model can be fed with two signals corresponding to two different MW sequences, such as CPMG sequences, with different number of pulses (for example, N=32 and N=256). Using two or more signals enables to gain more information about the system and to detect nuclei in a wider range of parameters (Azj, A⊥j).

In an implementation form of any of these aspects, a convolutional neural network is used. In this case, the one or more input signals are fed to a corresponding number of 1-dimensional convolutional blocks which process each signal independently. The one or more convolutional blocks can be configured in different manners, such as with one or more convolutional layers, normalization layer, activation functions, etc. A fully connected block can be used following the one or more 1-dimensional convolutional blocks. The last layer of the fully connected block can be reshaped in a rectangular image. The, for example, reshaped output of the fully connected block can be fed to a second convolutional block, which can be implemented in different manners. An output convolutional layer is typically used following the second convolutional block.

Prior to feeding the AI model with a sample (i.e. an optical response signal of a crystalline structure obtained following the first aspect of this disclosure), so that the number of nuclei within the sample and corresponding parameters (for example coupling constant pairs (Azj, A⊥j)) are calculated by the model, the learning model needs to be trained with a batch of samples, each containing a random number of nuclei (for example ranging from 1 to 30 nuclei). Each nucleus in the batch is characterized by random values of Az and A⊥ within predefined ranges of Az and A⊥.

The training of the AI model can be as follows. A quantum node consisting of a defect color center (such as an NV center) and n nearby non-zero spin nuclei (such as n 13C) with a certain Larmor frequency are considered. A MW radiation driving to the sensor is applied, thus implementing pulse sequences (for example, trains of *π*-pulses over the defect color center according to a CPMG sequence). The defect color center can then be measured. Repeating this process several times to average the response, the survival probability (Px) of the initial state can be computed. To train the model, several millions of different samples can be randomly generated, covering the possible distributions of a random number of 13C in the vicinity of the defect color center.

A modelized signal, instead of real experimental signals, is preferably used because a wide range of samples is needed to pre-train the network. The fine tuning of the model is then done with experimental (real) signals obtained in lab from actual crystalline structures.

After training and testing the neural network, the test outputs exhibit distinct cluster of pixels, ideally resembling Gaussian functions, with each cluster representing a nucleus. The centroid of each cluster must be extracted, enabling the computation of the coupling constant pair (Az, A⊥). By doing so, the predicted values can be compared to the true values, facilitating the evaluation of the neural network's performance.

The atomic signature, unique tag obtained from the atomic signature and additional uses of the atomic signature therefore take into account the effects of the local non-zero spin atomic distribution surrounding each defect color center, which naturally occurs in, for example, diamond crystals.

It has to be noted that all devices, elements, units and means described in the present application could be implemented in the software or hardware elements or any kind of combination thereof, provided such combinations fall within the scope of the invention as defined by the appended claims.

All steps which are performed by the various entities described in the present disclosure as well as the functionalities described to be performed by the various entities are intended to mean that the respective entity is adapted to or configured to perform the respective steps and functionalities. Even if, in the following disclosure of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof.

### BRIEF DESCRIPTION OF THE DRAWINGS

The above-described aspects and implementation forms of the present disclosure are explained in the following description of embodiments with respect to the enclosed drawings, in which:
FIG. 1 schematically illustrates a crystalline structure comprising a plurality of defect color centers according to this disclosure.
FIG. 2 schematically illustrates a defect color center (in this case, an NV center) of a crystalline structure and three exemplary non-zero spin nuclei (in this case, C-13) comprised in the local environment of the defect color center.
FIG. 3 schematically illustrates several defect color centers and their non-zero spin nuclei of a crystalline structure.
FIG. 4A and FIG. 4B show schematic views of a system for analyzing a crystalline structure comprising defect color centers according to embodiments of this disclosure.
FIG. 5 shows (a) an exemplary MW pulse sequence (top) to be applied to the crystalline structure in embodiments of this disclosure and an f (t) modulation function (bottom) resulting from the application of the π-pulses in the CPMG sequence. FIG. 5 (b)-(c) show exemplary results of the survival probability calculated at different magnetic fields.
FIG. 6 schematically illustrates an artificial intelligence model used to extract the parameters which characterize the atomic signature of the crystalline structure in embodiments of this disclosure.
FIG. 7 schematically illustrates an output of the neural network for the training process, according to embodiments of this disclosure.
FIG. 8 shows a schematic view of a system for analyzing a crystalline structure comprising a plurality of defect color centers according to embodiments of this disclosure.
FIG. 9 shows a schematic view of a system for analyzing a crystalline structure comprising a plurality of defect color centers according to embodiments of this disclosure.
FIG. 10 shows a schematic view of a system for analyzing a crystalline structure comprising a plurality of defect color centers according to embodiments of this disclosure.
FIG. 11A to 11C show methods for analyzing a crystalline structure comprising at least one defect color center according to embodiments of this disclosure.
FIG. 12 shows a flowchart of an exemplary use of a unique tag in a blockchain application according to embodiments of this disclosure.
FIG. 13A, 13B (B1-B2) and 13C (C1-C2) show results of execution of the artificial intelligence model of FIG. 6.

### DETAILED DESCRIPTION OF EMBODIMENTS

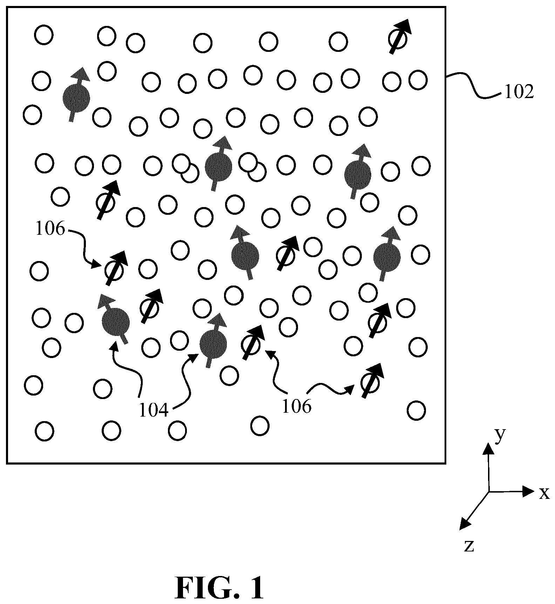

A crystalline structure 102 analyzed in this disclosure is schematically depicted in FIG. 1. The crystalline structure 102 comprises a plurality of defect color centers 104. The crystalline structure 102 may further comprise a local non-zero spin atomic distribution of nuclei 106 surrounding each defect color center 104.

The crystalline structure 102 may be a diamond crystal and the plurality of defect color centers 104 may comprise NV centers. In this case, the local non-zero spin atomic distribution of nuclei corresponding to each of the NV centers may comprise a plurality of active 13C nuclei 106 surrounding the corresponding NV center in the diamond crystal, as depicted schematically in FIG. 1. Alternatively, the crystalline structure 102 may be a silicon carbide (SiC) material and the plurality of defect color centers 104 comprises silicon vacancy (V_{Si}) defects. In this case, the local non-zero spin atomic distribution 106 corresponding to each V_{Si} defect in SiC may comprise a plurality of magnetically active 13C nuclei and magnetically active 29Si nuclei surrounding the corresponding V_{Si} defect in the SiC material.

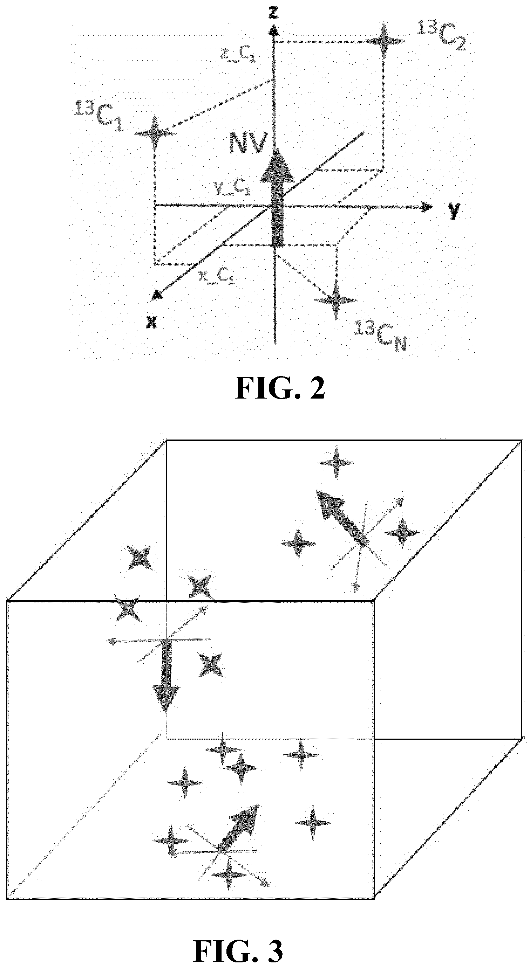

An NV center of a crystalline structure and three exemplary 13C of the local magnetic environment of the NV center are illustrated in FIG. 2. The spatial position XYZ of each 13C is represented with respect to the XYZ position of the NV center (aligned with the Z-axis). Similarly, FIG. 3 illustrates a portion of a crystalline structure showing three NV centers (or other defect color centers) and their surrounding non-zero spin nuclei. In this context, the expressions "surrounding", "in the vicinity" or "nearby", applied to one or more nuclei with respect to a defect color center, refers to the capacity of those nuclei to generate a change in a received signal above the noise level.

In the method and system of this disclosure, each defect color center acts as a sensor that is sensitive to the surrounding nuclei (or at least to some surrounding nuclei) forming its local non-zero spin atomic distribution. This sensitivity is reflected in the collected signal(s), as will be explained later. In other words, each defect color center acts as a sensor capable of interrogating or listening to the information provided by its nearby coupled non-zero spin nuclei.

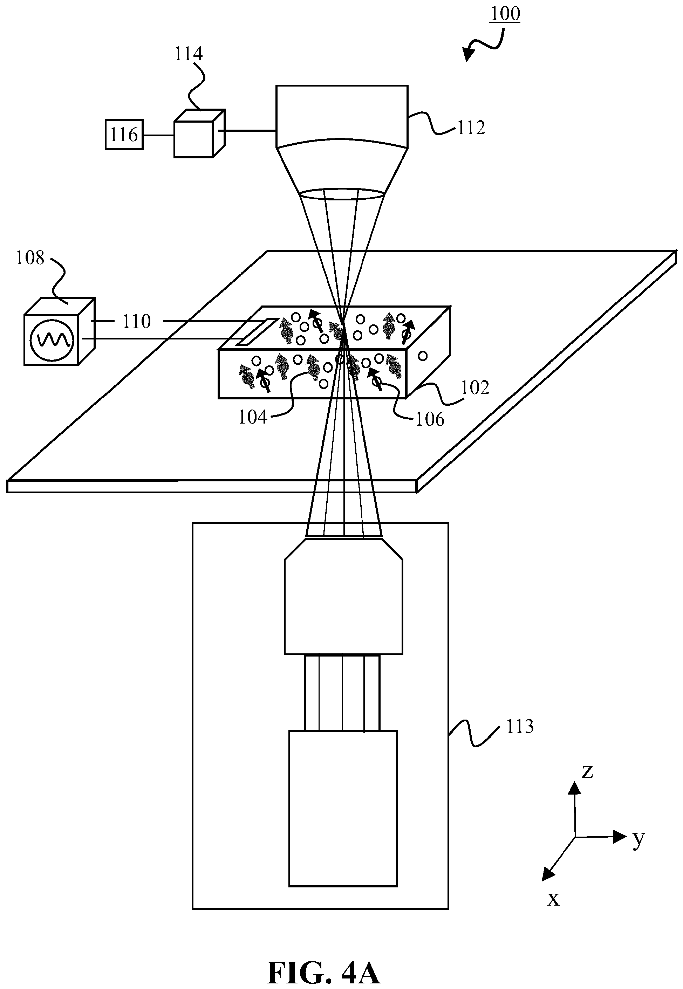

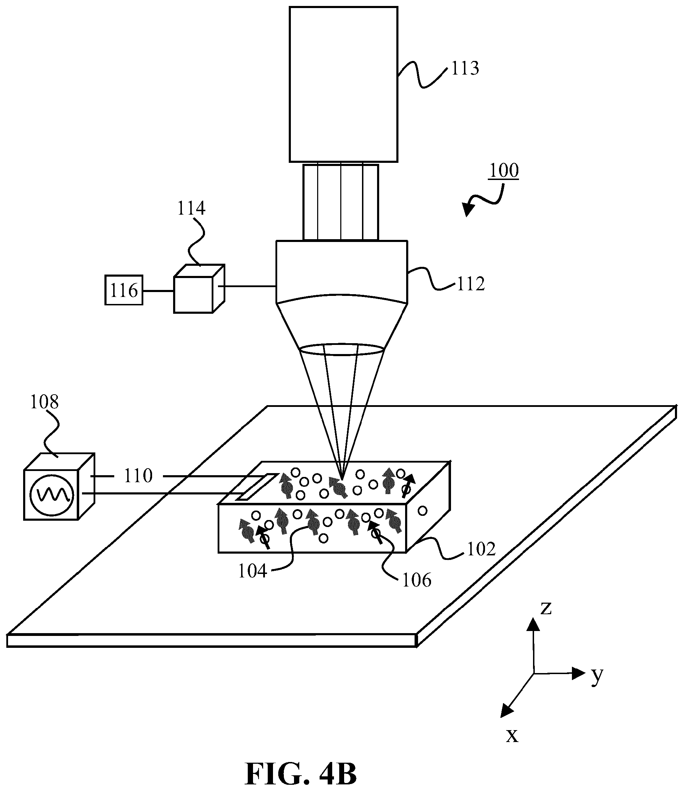

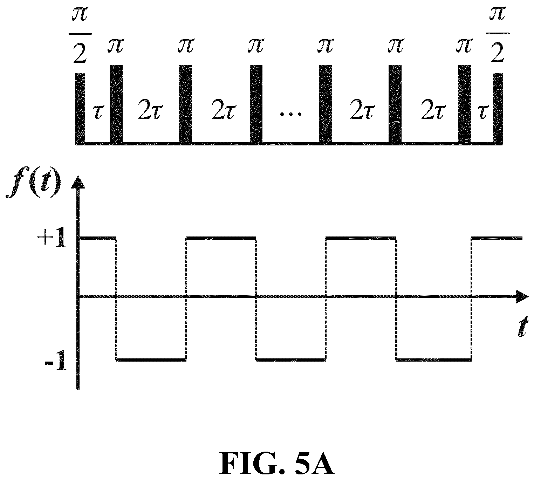

FIG. 4A and FIG. 4B show schematic views of exemplary embodiments of a system 100 for analyzing the crystalline structure 102 according to this disclosure. The system 100 comprises a MW source 108, a light source 113 to apply an optical radiation to the crystalline structure 102 to excite at least one defect color center 104, a device 112 to detect a response of the crystalline structure and a processor 114. The processor 114 is depicted close to the other elements, but could be alternatively disposed remotely, such as in the cloud. In this embodiment the device 112 is an optical device 112 based on focused light, for example a confocal microscope. In FIG. 4B the light source 113 and the detection device 112 are integrated in a same apparatus. In FIG. 4A the light source 113 and the detection device 112 are separate devices. In the particular example of FIG. 4A a confocal means is depicted following the light source as such, the confocal means being only required if the detection device 112 is a confocal device. The MW source 108 is configured to apply at least one MW field sequence 110 to the crystalline structure 102. A magnetic field can also be applied, if necessary (not shown), for example aligned with the z axis of the defect color centers of the structure. The at least one MW field sequence 110 may comprise a dynamical decoupling sequence for the defect color centers 104, as it is explained later in this disclosure. For example, a CPMG pulse sequence can be applied, as illustratively shown in FIG. 5(a)(top). In FIG. 5(a)(top), a π/2 pulse is applied to set the electron spin of a defect color center in a superposition state of the two energies of the two-level energy system m=0 and m=1 or m=0 and m=-1. Using the Bloch sphere representation a π/2 pulse is applied to rotate the electron spin of a defect color center from the z axis to the XY plane. Subsequently, a series of N π-pulses is applied. Finally, another a π/2 pulse is applied to set the spin back to the initial state and proceed to the measurement. In the Bloch sphere representation a π/2 pulse is applied to rotate the spin back to the z axis. The optical device 112 is configured to detect, for at least one defect color center 104 of the crystalline structure, an optical response of the crystalline structure 102 to the applied at least one MW field sequence 110. The optical device 112 detects the optical response of individual defect color centers 104.

The optical device 112 comprises standard and well-known components that are not shown in FIG. 4A-B. A confocal microscope may be used. The precision offered by standard confocal microscopes has made them a customary tool to analyze microscopic defects in crystalline structures, for example NV centers in diamond crystals. The confocal arrangement of conventional confocal microscopes may reduce the volume of the crystalline structure 102 subjected to the at least one MW field sequence 110 to about 1 µm³ and, hence, may improve the selectivity of a spin-state excitation.

As said, to excite at least one defect color center of the structure 102, an optical source 113, such as a laser source, is used to apply an optical radiation (laser radiation) to the crystalline structure 102. The optical radiation, such as laser light, can optically be focused onto a defined spot at a specific depth within the crystalline structure 102. In response to the applied laser light and to the applied at least one MW field sequence 110 (and, if necessary, to the applied magnetic field), the crystalline structure 102 emits an optical signal, for example fluorescent light, at exactly this point. In the particular non-limiting case of a confocal microscope, the objective (not shown) of the optical device 112 collects the emitted light from a diffraction limited volume in the focal plane. This light is then focused through a small aperture or pinhole in front of the image plane of a detector (not shown). Hence, all light that is not originating from the focal plane is canceled out and is not detected.

The optical device 112 is configured to capture the optical response produced by individual defect color centers of the crystalline structure 102. The above process can be repeated, thereby enabling the detection of the optical response emitted by each of the defect color centers 104 individually, until a surface of the crystalline structure 102 is scanned. For example, the scanned surface may comprise a surface of the crystalline structure 102 facing the optical device 112, as schematically depicted in FIG. 4A-B.

For NV centers in a diamond crystalline structure, in the very particular implementation in which a confocal microscope is used, the confocal microscope 112 may have, for example, a numerical aperture NA=0.8 and the excitation laser light may comprise green laser light with wavelength *λ*=532 nm.

For each one of the defect color centers and corresponding at least one non-zero spin nucleus located in the vicinity thereof, an optical response of the crystalline structure is thus detected.

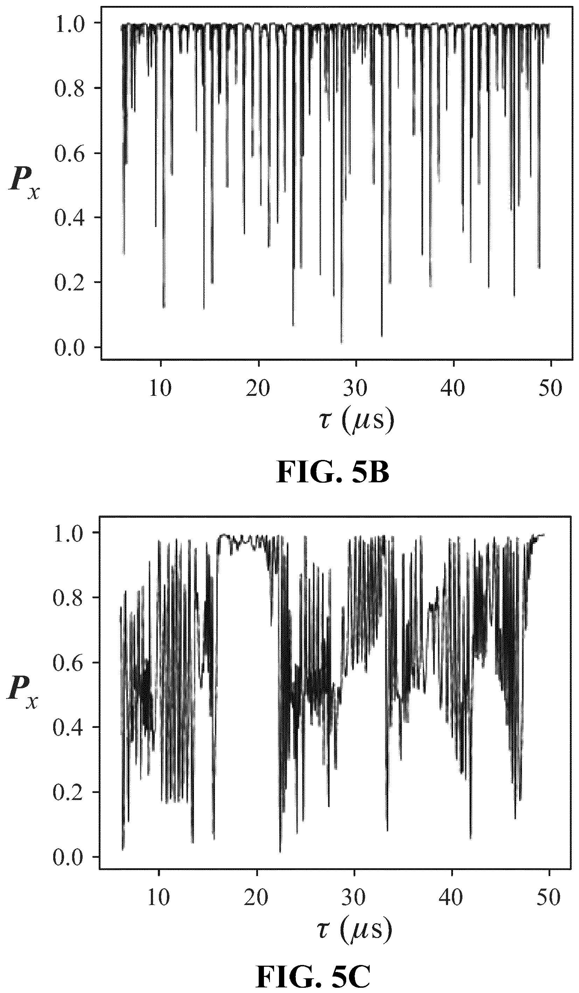

The optical response of the crystalline structure 102 may comprise a PL spectrum emitted by each of the defect color centers 104 in response to the applied at least one MW field sequence 110. Examples of optical response signals (PL spectrum) are shown in FIG. 5 (b) and (c). FIG. 5 (b) and (c) represent the optical response captured by the optical device to the applied excitation and MW field. In these figures, the optical response is represented as a survival probability signal. By employing a microwave driving, one can apply pulses to a defect color center, specifically implementing a pulse sequence such as the Carr-Purcell-Meiboom-Gill (CPMG) sequence. This sequence involves the application of N *π*-pulses in the XY plane with an interpulse delay of 2*τ.* Initializing the defect color center in an eigenstate of *σₓ* and applying the aforementioned pulse sequence enables optical measurement of the final state of the sensor (|0>ₓ or |1>ₓ). Repeating this process Nₘ times, one can estimate the probability Pₓ of the state of the defect color center being preserved. This survival probability can be calculated for various values of *τ* (half the interpulse delay), generating a signal of Pₓ as a function of *τ*.

The optical response signals obtained after submitting at least one defect color center of the crystalline structure to the settlement already described in FIG. 4A-B vary depending on at least one property of the corresponding local local non-zero spin atomic distribution corresponding to each of the defect color centers 104. Examples of these properties are the relative positions XYZ of the nuclei in relation to the defect color center (see FIG. 2 and 3) or the hyperfine frequency parameters (also referred to as hyperfine coupling parameters or dipolar coupling), represented as *A̅,* of the nuclei of a defect color center.

In other words, the PL spectrum of each defect color center 104 depends on the influence of non-zero spin nuclei surrounding the defect color center (these nuclei forming the local non-zero spin atomic distribution 106 of the corresponding defect color center 104). This means that the PL spectrum emitted by each defect color center 104 after being irradiated with the at least one MW field 110, is affected by its corresponding local non-zero spin atomic distribution 106.

In general, while a MW field sequence 110 may drive transitions between the spin states of each defect color center 104, its corresponding local non-zero spin atomic distribution 106 may shift a resonance feature of the defect color center 104. This results in a change in the PL spectrum emitted by the defect color center 104.

Since the local non-zero spin atomic distribution 106 corresponding to a defect color center 104 is typically different from the local non-zero spin atomic distribution 106 corresponding to another defect color center 104, a defect color center 104 emits a PL spectrum that is different from the PL spectrum emitted by another defect color center 104 in response to a same MW field 110 applied.

The at least one property of the local non-zero spin atomic distribution 106 corresponding to each defect color center 104 comprises at least one of a precession frequency of the local non-zero spin atomic distribution 106 (that is to say, the hyperfine frequency parameters (also referred to as hyperfine coupling parameters) of the nuclei of a defect color center), a configuration of the local non-zero spin atomic distribution 106, and a position of the local non-zero spin atomic distribution 106 relative to the corresponding defect color center 104. The characterization of the local non-zero spin atomic distribution 106 relative to the corresponding defect color center 104 may comprise a relative position in a two-dimensional coordinate space or in a three-dimensional coordinate space, such as the relative positions XYZ of the nuclei surrounding a defect color center in relation to the defect color center or the hyperfine coupling parameters *A̅*.

Upon detecting the optical response of the crystalline structure 102 to the applied at least one MW field sequence 110 at each position, i.e., the optical response of each defect color center 104 of the plurality of defect color centers 104, the processor 114 is configured to determine an atomic signature of the crystalline structure. The atomic signature characterizes the local non-zero spin atomic distribution of one or more defect color centers. In other words, the atomic signature comprises information of the local non-zero spin atomic distribution of one or more defect color centers. This local non-zero spin atomic distribution is composed of the non-zero spin nuclei of a defect color center. This atomic signature comprises, represents or depends on the already mentioned at least one property of the local non-zero spin atomic distribution 106 corresponding to each of the defect color centers 104.

The determination of an atomic signature of the crystalline structure may comprise extracting from the optical response (that is, from the PL spectrum) emitted by each defect color center 104 the at least one property of the corresponding local non-zero spin atomic distribution 106 corresponding to the defect color center 104.

For the example of NV centers in diamond, it should be noted that the 13C nuclei distribute randomly in the diamond lattice, and their hyperfine interactions with the electron spin of the NV center are position-dependent. The 13C nuclei closest to the NV center can be directly addressed with selective MW pulses. Accordingly, the NV centers can be used as a probe or sensor to identify the precession frequency of each 13C nucleus in their surroundings. By analyzing the PL spectrum emitted by each NV center in response to the applied at least one MW field sequence 110, the processor 114 may be configured to extract the precession frequency of each 13C nuclei defining the local non-zero spin atomic distribution 106 corresponding to each NV center. This precession frequency (hyperfine frequency) can be the atomic signature of the crystalline structure.

Dynamical decoupling (DD) techniques are well-studied processes that limit the interaction of an NV center to a certain frequency range, eliminating the effect that any other signal would have in its spin state. When a DD sequence, which is realized through MW fields, matches a precession frequency of a nearby 13C nucleus of the corresponding local non-zero spin atomic distribution 106, the NV center and the nucleus interact with each other and the quantum state of the NV changes accordingly. This change can be read out by using, for example, the confocal microscope (optical device 112), which optically excites a spin state-dependent fluorescent transition of the NV center and collects the emitted PL spectrum.

Further, by sweeping over target frequencies, the PL spectrum emitted by each NV center may encode the precession frequency, additionally or alternatively the relative positions of the surrounding magnetically active 13C nuclei (i.e., the relative position of the corresponding local non-zero spin atomic distribution 106). The interaction between the 13C nuclei and the NV center is mediated by a dipolar coupling, which grows inversely with the third power of the distance between them. Thus, the PL emitted by each defect color center 104 may be used to detect and extract information of the local non-zero spin atomic distribution 106corresponding to the defect color center 104. Further, it is mentioned that the local non-zero spin atomic distribution 106 corresponding to an NV center may comprise the 13C nuclei closest to the NV center.

Thus, each of the at least one MW field sequence 110 applied to the crystalline structure 102 may comprise a DD sequence.

The at least one MW field sequence 110 may comprise a plurality of MW field sequences 110, and each of the MW field sequences 110 are different from each other. The at least one MW field sequence 110 may comprise, for example but not as a limitation, a Carr-Purcell-Meiboom-Gill (CPMG) sequence, a Uhrig dynamical decoupling (UDD) protocol, any sequence of the XY family, or the like. Additionally or alternatively, a total number of MW pulses and/or a duration of each MW pulse of each of the MW field sequences 110 may be different from each other.

In the example of NV centers in a diamond crystal, the precession frequency of the local non-zero spin atomic distribution 106 corresponding to each of the defect color centers 104 may comprise the precession frequency of each magnetically active 13C nucleus close to each NV center.

The relative position of the local non-zero spin atomic distribution 106 corresponding to each of the defect color centers 104 may comprise the relative position of each magnetically active 13C nucleus with respect to the NV center.

Further, the configuration of the local non-zero spin atomic distribution 106 corresponding to each of the defect color centers 104 may comprise a total number of magnetically active 13C nuclei nearby the NV center.

To generate the atomic signature of the structure, the information of the response signal (optical response in the implementation of FIG. 4A-B) must be decoded. This is not straight-forward for several reasons, including these signals being characterized by being very weak (i.e. of low intensity), and at the same time having a strong noise component. To extract the parameters that will form the atomic signature (such as relative position of the nuclei with respect to the defect color center, or their hyperfine frequency parameters) of the crystalline structure, an artificial intelligence model is used. This model harnesses the information encoded in the signals to characterize the local non-zero spin atomic distribution 106, for example, the relative spatial position (XYZ) of the nuclei with respect to the defect color center or the hyperfine coupling parameters (dipolar coupling constant *̅A̅*̅) between a nucleus and a defect color center.

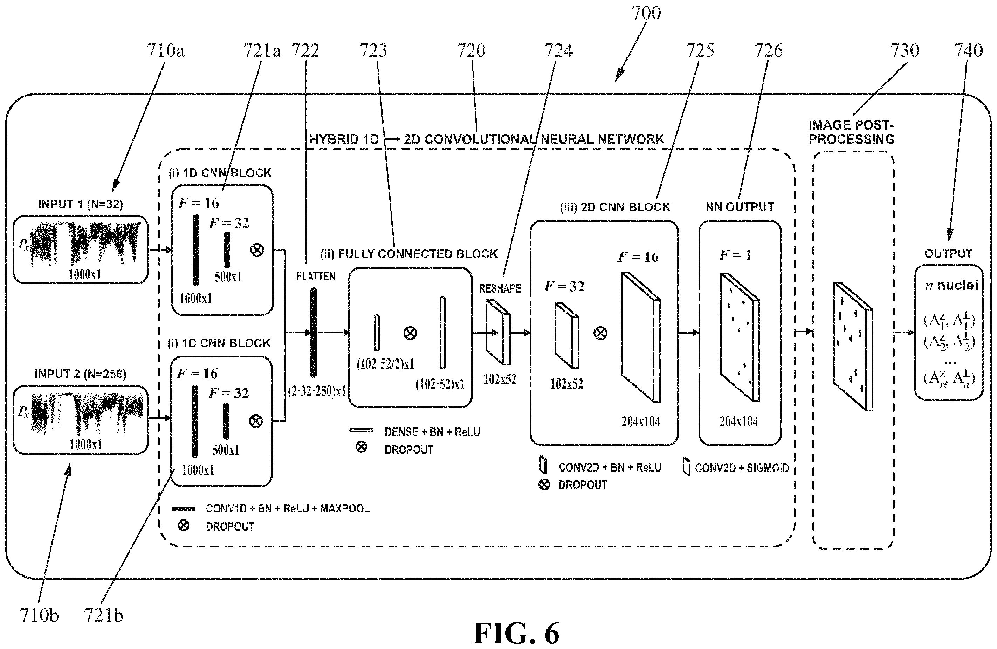

FIG. 6 shows a schematic representation of an exemplary embodiment of artificial intelligence model 700 used to extract the parameters which form the atomic signature of the structure. In this exemplary embodiment a convolutional neural network 720 is combined with an image-post processing stage 740. The neural network 720 takes two input signals 710a, 710b: the first one 710a corresponds to a CPMG sequence with N = 32 pulses, and the second one 710b corresponds to a CPMG sequence with N = 256 pulses. Each sequence could have a different number N of pulses. What is more, less or more than two input signals could be fed to the neural network 720, in which case the subsequent number of 1-dimensional convolutional blocks 721a, 721b could be reduced or increased correspondingly. The selected two signals 710a, 710b enable to gain more information about the system and to detect nuclei in a wider range of parameters (Azj, A⊥j). In block (i) of the neural network 720, each input signal is independently processed through two 1-dimensional convolutional blocks 721a, 721b. Each block 721a, 721b comprises two convolutional layers with F filters of kernel size 3, followed by a Batch Normalization (BN) layer, a ReLU activation function, and a max-pooling layer with a window size of 2. Other configurations of blocks 721a, 721b can alternatively be used. The flattened outputs 722 from these convolutional blocks are then concatenated and connected to block (ii), a fully connected block 723. The last dense layer in this block is reshaped 724 into a rectangular image. Within block (iii), the second convolutional layer 725 is a transposed convolutional layer with a stride of 2, effectively doubling the image's width and height. Both 2-dimensional convolutional layers 725 utilize F filters with a kernel size of (3, 3). Other configurations of blocks 722, 723, 724 and 725 can alternatively be used. Block (iii) is subsequently connected to an output convolutional layer 726 of the neural network 720. The output of the neural network 720 is followed by an image post-processing module 730 to extract the number of nuclei (n) within the sample and the corresponding coupling constant pairs (Azj, A⊥j).

The shown artificial intelligence model 700 is a non-limited example of model that can be used to extract the parameters which form the atomic signature of the structure. This means that other AI models may be used alternatively to extract the mentioned parameters.

Prior to feeding the AI model 700 with a sample (i.e. an optical response signal of a crystalline structure obtained with the setup of FIG. 4A-B), so that the number of nuclei (j) within the sample and the corresponding coupling constant pairs (Azj, A⊥j) are calculated by the model 700, the learning model, such as deep learning model (neural network 720 of FIG. 6) needs to be trained. The model 700 has been trained with a batch of samples, each containing a random number of nuclei ranging from 1 to 30. Each nucleus was characterized by random values of Az and A⊥ within the ranges Az ε [-100, 100] kHz and A⊥ ε [2, 102] kHz.

The training is explained next. A quantum node consisting of an NV sensor and n 13C (also referred to as ¹³C) nearby nuclear spins with Larmor frequency ωL=γn*Bz* has been considered, wherein Bz refers to the applied magnetic field and γn is the gyromagnetic ratio of the 13C nuclei. Applying a MW radiation driving to the sensor, one can implement pulse sequences. In particular, trains of *π*-pulses over the defect color center according to a CPMG sequence have been considered, as shown in FIG. 5(a) top, after which the defect color center is measured. Repeating this process several times to average the response, the survival probability (Px) of the initial state can be computed. This probability can be calculated for various values of *τ* (half the interpulse delay of the sequence), generating a signal of *Px* as a function of *τ.* The model takes two input signals (Px) coming from CPMG sequences with number of pulses N=32 and N=256. This approach ensures a reasonable coherence time required for computing these pulse sequences, which is on the order or milliseconds. It is however remarked that a different number of pulses N in each sequence, or even a different number of sequences (for example a single one) could be used instead. For example, if a single sequence is used, the neural model 720 is adapted to have a single input block 721a. In order to train the model, several millions of different samples have been randomly generated, covering the possible distributions of a random number of ¹³C in the vicinity of the defect color center.

As a matter of example, FIG. 5 (a) (top) shows an exemplary CPMG pulse sequence. Initially, a π/2-pulse is applied to rotate the NV electron spin to the XY plane. Subsequently, N π-pulses are applied, and finally, another π/2-pulse is applied before the measurement. FIG. 5 (a) (bottom) shows a modulation function resulting from the application of the π-pulses in the CPMG sequence. FIG. 5 (b)-(c) show the survival probability Px calculated at a high magnetic field Bz = 0.056 T and at a low magnetic field Bz = 0.0056 T, respectively. Each sequence contains N = 32 π-pulses, and Px is sampled Np = 1000 times in the range τ ∈ [6, 50] µs. In this example, the node contains an NV center and 3 nuclei with (3, 75) kHz, (-45, 42) kHz, and (23, 4) kHz.

A modelized signal, instead of real experimental signals, has been used because a wide range of samples is needed to pre-train the network. Obtaining millions or even thousands of different samples is very unrealistic in experimental measurements. The fine tuning of the model is done with experimental (real) signals obtained in lab from actual crystalline structures.

After training and testing the neural network, the test outputs exhibit distinct cluster of pixels, ideally resembling Gaussian functions, with each cluster representing a nucleus. The centroid of each cluster must be extracted, enabling the computation of the coupling constant pair (Az, A⊥). By doing so, the predicted values can be compared to the true values, facilitating the evaluation of the neural network's performance.

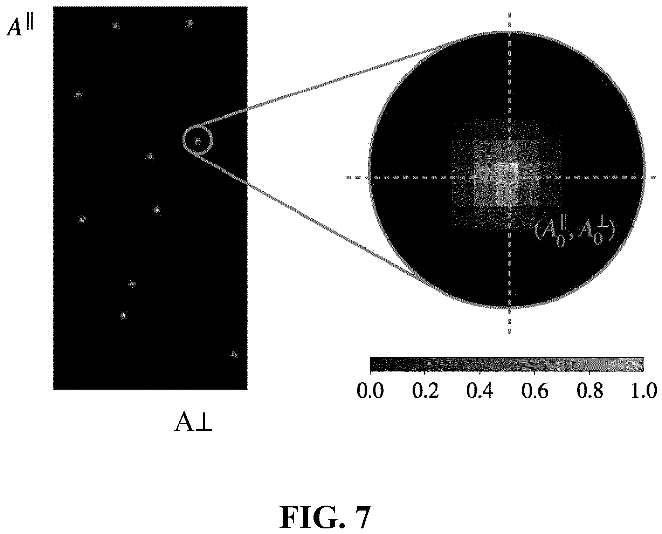

FIG. 7 shows an output of the neural network 720 for the training process. 10 nuclei with random coupling constants in ranges Az ∈ [-100, 100] kHz and A⊥ ∈ [2, 102] kHz are represented in this sample. Each of these nuclei is represented by a cluster of pixels, as seen in the amplified circle (right). This cluster is composed of one central pixel (the closest to the true values Az0 and A⊥0), the nearest neighbours (8 pixels) and the next-nearest neighbours (16 pixels).

The post-processing stage 726 (artificial vision-based) permits to extract valuable information from the reshaped images obtained from block 726. In stage 730, a thresholding of the smoothed image is performed and the sets of adjacent pixels with a connectivity routine are grouped. Finally, an area filter is applied to determine which predicted clusters qualify as nuclei.

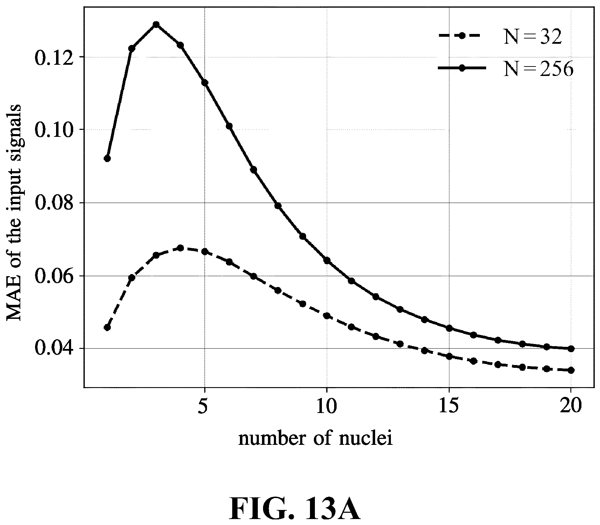

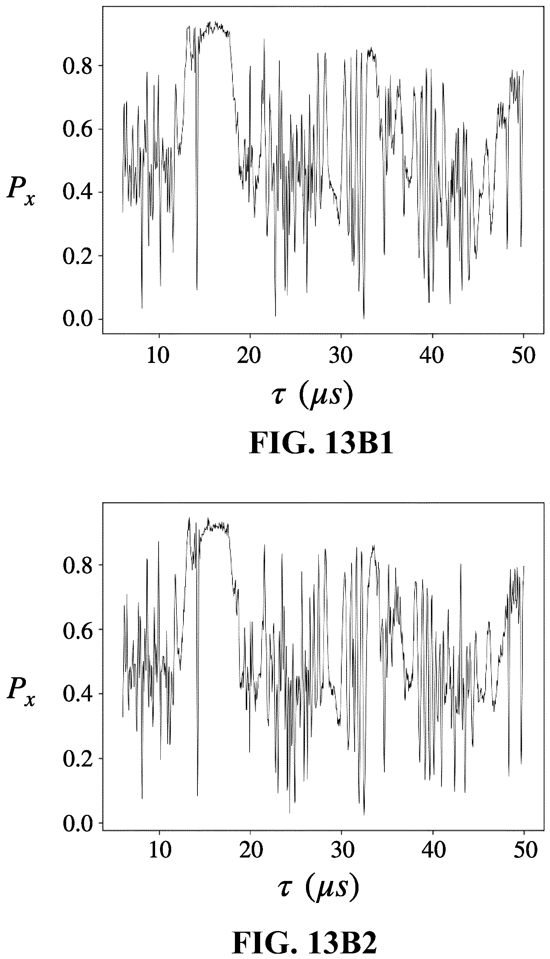

FIG. 13A-C shows several graphs representing results obtained by the artificial intelligence model 700 used to extract parameters which form the atomic signature of the structure. In particular, FIG. 13A shows Mean Absolute Error (MAE) between original input signals and signals reconstructed using the nuclei predicted by the model 700, represented by the solid (dashed) line for N=256 (N=32) *π*-pulses in the CPMG sequence. FIG. 13B (FIG. 13B1) shows an original (or true) signal from a CPMG sequence with N=32 *π*-pulses for a sample containing 4 nuclei. FIG. 13B (FIG. 13B2) shows a signal reconstructed using the model-predicted nuclei from the same sample as (FIG. 13B1). The MAE between the signals in (B1) and (B2) is 0.0712.

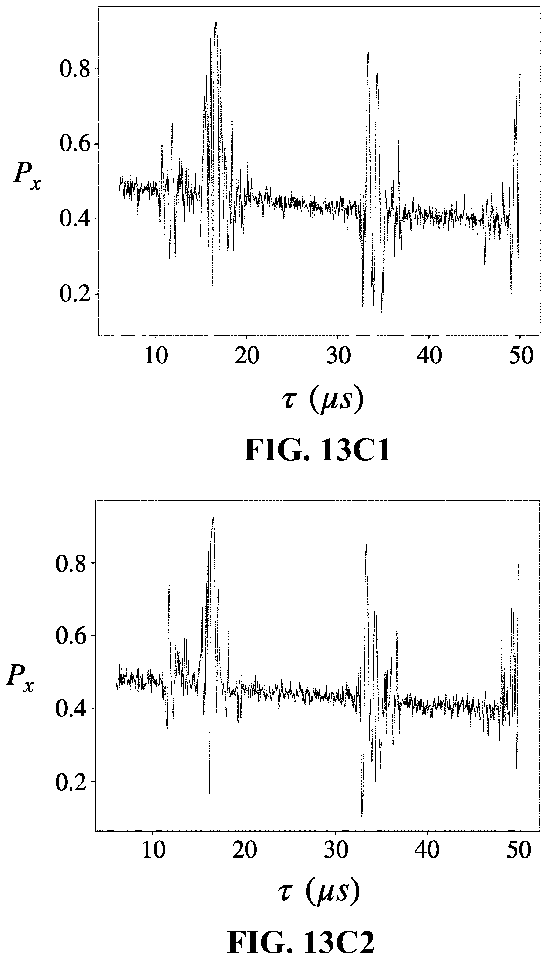

FIG. 13C (FIG. 13C1) shows a true signal from a CPMG sequence with N=32 *π*-pulses for a sample containing 16 nuclei. FIG. 13C (FIG. 13C2) shows a signal reconstructed using the predicted nuclei. The MAE between the signals in (FIG. 13C1) and (FIG. 13C2) is 0.0375.

Turning back to the embodiment of FIG. 4A-B, once the atomic signature has been obtained, the processor 114 is further configured to analyze the crystalline structure 102 and to generate a unique tag 116 from the crystalline structure 102 based on the atomic signature, that is to say, based on the at least one property of the local non-zero spin atomic distribution corresponding to each of the defect color centers 104 extracted from the response (optical response in FIG. 4A-B) of the crystalline structure 102 when the crystalline structure is exposed to at least one MW field sequence 110 and excited with a light source (and exposed to an applied magnetic field if required). With the set of inferred parameters which form the atomic signature a unique tag associated to the crystal is built.

The atomic signature is then converted into a unique tag 116. In other words, a unique tag 116 is generated from the atomic signature. The simplest way to build the tag is by concatenating the parameters forming the atomic signature of the structure. For example, when the structure is diamond, the color defect centers are NV centers and the non-zero spin nuclei are 13C nuclei, the atomic signature man comprise the hyperfine coupling parameters of each 13C nuclei (assuming N 13C nuclei) of at least one NV center. In this case, the tag can be a concatenation of these parameters, for example: {Hyperfine coupling parameters 13C*1*, Hyperfine coupling parameters 13C2, ..., Hyperfine coupling parameters 13CN}. The atomic signature can comprise, in addition to the hyperfine coupling parameters or instead of them, the relative spatial position of the 13C nuclei. The tag can be a concatenation of these parameters, for example: {XYZ coordinates 13C*1*, XYZ coordinates 13C2, ..., XYZ coordinates 13CN}.

The security level of the tag can be increased using a function dependent on the atomic signature (in other words, on the parameters forming the signature). For example, any type of function dependent on those parameters, that is biunivocal and exclusive, can be used. Because this function will be unknown by external entities, even if an external entity has access to a valid tag (i.e. crystal), the external entity will not be able to generate the associated tag.

In addition to the information comprised in the atomic signature (information of the non-zero spin nuclei distribution of the at least one defect color center 104), the unique tag 116 for the crystalline structure 102 may comprise additional information, such as information indicating the total number of defect color centers 104 comprised in the crystalline structure 102 and information indicating the applied at least one MW field sequence 110.

The unique tag 116 may comprise any suitable format. For example, the unique tag 116 may comprise an alphanumeric format or may comprise a binary format. Further, the unique tag 116 may be encoded in the form of a single value or may comprise a plurality of values, for example in the form of a list or an array.

The processor 114 may be further configured to generate the unique atomic signature and subsequent tag 116 by processing the response of the crystalline structure 102 and extracting at least one property of the local non-zero spin atomic distribution 106 corresponding to each of the defect color centers 104 in any suitable manner.

The atomic signature and subsequent tag 116 may be generated based on the response of the total number of the plurality of defect color centers 104 of the crystalline structure 102. Alternatively, the processor 114 may be configured to generate the atomic signature and subsequent tag 116 based on the response of a partial number of the plurality of defect color centers 104 of the crystalline structure 102.

The unique tag 116 may comprise the atomic signature of the local non-zero spin atomic distribution of one defect color center, or the atomic signature of local non-zero spin atomic distribution of several defect color centers.

The 13C nuclei surrounding a NV center typically comprise a relaxation time that is smaller than the relaxation time of the NV center. Due to the larger relaxation time of the NV center the hyperfine interaction of weekly coupled 13C nuclei can be taken into account. Thus, the response of each defect color center 104 at low temperatures may be different than the PL spectrum emitted at room temperature and may encompass further details of the corresponding local non-zero spin atomic distribution 106.

When the system 100 is operated at different temperatures, the atomic signature and subsequent unique tag 116 generated for the crystalline structure 102 may further comprise information indicating the temperature at which the response, such as optical response, of each defect color center 104 is detected.

Additionally or alternatively, a unique atomic signature and subsequent tag 116 may be generated at each temperature at which the response, such as optical response, of each defect color center 104 is detected. Thereby, the crystalline structure 102 may be associated with one or more unique tags 116, each of the unique tags 116 generated at a different temperature.

The processor 114 may be located locally with respect to the system for analyzing a crystalline structure 102, or remote from this system (i.e. offside). When the processor is implemented remotely, it can be implemented in distributed servers, cloud servers or the like. The processor 114 may comprise processing circuitry (not shown) configured to perform, conduct or initiate the various operations of the processor 114 described herein. In particular, the processor 114 may carry out the execution of the AI model 700. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors. The processor 114 may further comprise memory circuitry, which stores one or more instruction(s) that can be executed by the processing circuitry, in particular under control of the software. For instance, the memory circuitry may comprise a non-transitory storage medium storing executable software code which, when executed by the processor 114 or the processing circuitry, causes the various operations of the processor 114 to be performed.

The exemplary embodiment of FIG. 4A-B, thus, provides with a unique and non-reproducible tag 116 associated with the atomic signature determined for the crystalline structure 102 that is based on the unique response (for example optical response, in the form of a PL spectrum) of the individual defect color centers 104 as a consequence of: i) the local non-zero spin atomic distribution 106 corresponding to each defect color center 104, ii) the applied MW sequence and optical excitation; and if required: iii) an applied magnetic field. Owing to the fact that it is not possible to reproduce the local non-zero spin atomic distribution 106 of one or more defect color centers 104 in a crystal, the generated tag 116 associated with the crystalline structure 102 defines a unique fingerprint of the crystalline structure 102. Additionally, performing the detection of the response of each defect color center 104 at different temperatures, provides with further levels of security offered by the unique tag 116.

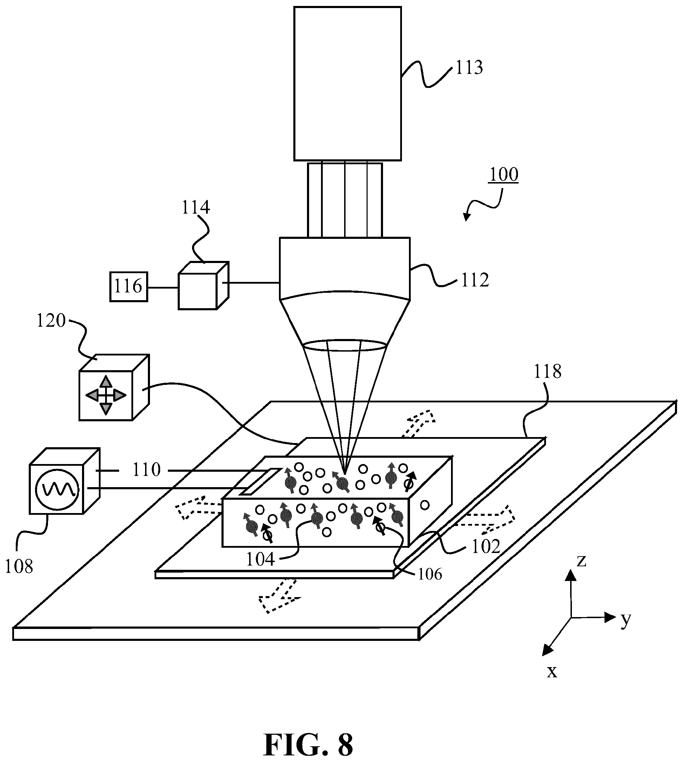

FIG. 8 shows a schematic view of an exemplary embodiment of a system 100 for analyzing the crystalline structure 102 according to this disclosure, which builds on the system 100 shown in FIG. 4B (but could alternatively build on the system shown in FIG. 4A). Same elements are labelled with the same reference signs. The afore-detailed description may be applied to the system 100 of FIG. 8, except for the hereinafter-mentioned differences.

The system 100 of FIG. 8 further comprises a stage region 118 configured to receive the crystalline structure 102, and a stage controller 120 configured to continuously change a position of the state region 118.

The stage region 118 may be a nanopositioning stage region with nanometer precision so that, once the spectrum of one of the defect color centers 114 is detected, the crystalline structure 112 is moved by means of the stage controller 120 and the state region 118, and another defect color center 104 can be targeted by the optical device, leading to the analysis of another region of the crystalline structure 102. Thereby, the stage region 118 and the stage controller 120 enable to automatically and continuously move the crystalline structure 102 so that the optical device 112 may scan a surface of the crystalline structure 102.

The surface of the crystalline structure 102 may comprise, for example, a surface facing the optical device 112.

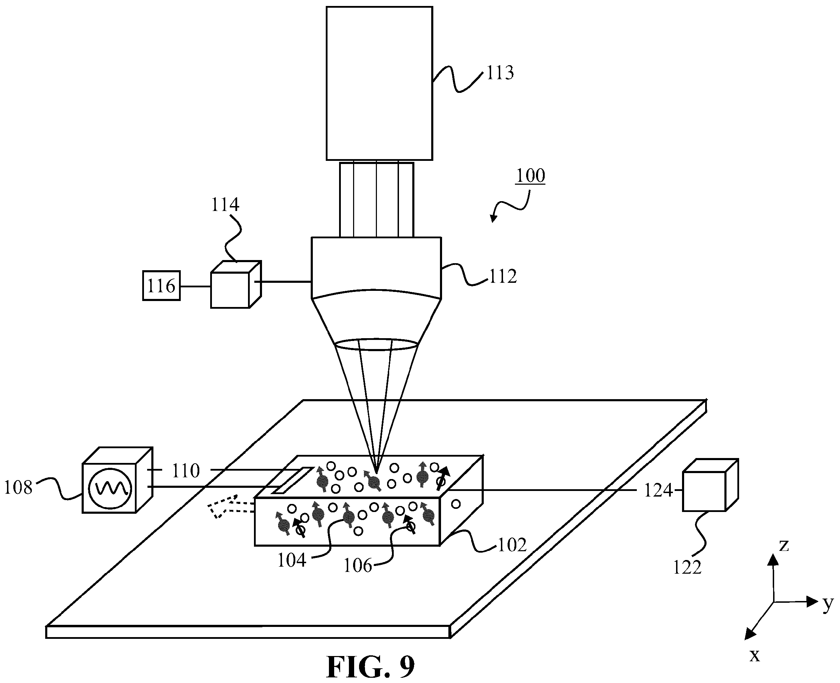

FIG. 9 shows a schematic view of another exemplary embodiment of a system 100 for analyzing the crystalline structure 102 according to this disclosure, which builds on the system 100 shown in FIG. 8 (but could alternatively build on the system of FIG. 8 based on the one shown in FIG. 4A). Same elements are labelled with the same reference signs. The afore-detailed description may be applied to the system 100 of FIG. 9, except for the hereinafter-mentioned differences.

The system 100 of FIG. 9 further comprises an RF controller 122 configured to apply at least one RF field 124 to the crystalline structure 102.

In this exemplary embodiment, the optical device 112 is further configured to detect, at several positions, the optical response of the crystalline structure 102 to both the applied at least one MW field sequence 110 and the applied at least one RF field 124.

It is to be mentioned that different local non-zero spin atomic distribution 106 located at different locations nearby an NV center could lead to similar PL spectra in response to the applied DD scheme (i.e., the at least one MW field sequence 110). However, the applied at least one RF field 124 may break the symmetry of the arrangement formed by a defect color center 104 and the corresponding local non-zero spin atomic distribution 106. This may result in a different optical response, that is, a different PL spectrum, emitted by each defect color center 104 in response to a same MW field sequence 110 that enables to determine the relative position of the respective local non-zero spin atomic distribution 106.

For the example of NV centers in diamond, when a characteristic flipping frequency of the NV spin states under DD sequence matches a Larmor frequency of a nearby 13C nucleus, the 13C nucleus can be addressed through resonant coupling. The applied at least one RF field 124 suppresses the nuclear dipolar interactions and allows to individually address and control of the 13C nuclei of the local non-zero spin atomic distribution 106 corresponding to each NV center.

From the different PL spectrum emitted by each defect color center 104 in response to the applied at least one MW field sequence 110 and to the applied at least one RF field 124, the processor may be configured to determine the relative position of the local non-zero spin atomic distribution 106 with respect to the corresponding defect color center 104.

The processor 114 may be configured to extract the relative position of each 13C nucleus of the local magnetic environment 116 corresponding to each NV center by using, for example, a quantum control method for individual spin manipulation and three-dimensional positioning of spin ensembles. This method enables the generation of tunable electron-nuclear coupling Hamiltonians while suppressing unwanted internuclear interactions. Thereby, each 13C nucleus can be addressed and controlled individually, thus enabling the reconstruction of individual vectors stemming from the hyperfine interaction between the NV center electron spin and the surrounding 13C nuclei.

When at least one RF field 124 is applied, the unique tag 116 for the crystalline structure 102 may additionally comprise information indicating the applied at least one RF field 124.

In this exemplary embodiment, the optical device 112 is further configured to perform the optical detection of the crystalline structure 102 at one or more temperatures.

Additionally or alternatively, a unique tag 116 may be generated at each temperature at which the optical response of each defect color center 104 is detected.

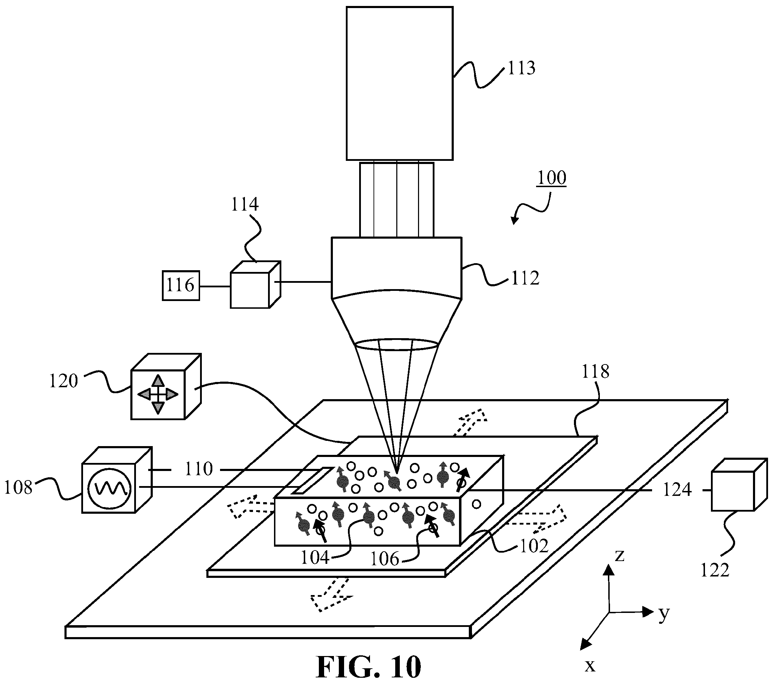

FIG. 10 shows a schematic view of an exemplary embodiment of a system 100 for analyzing the crystalline structure 102 according to this disclosure, which builds on the system 100 shown in FIG. 9. Same elements are labelled with the same reference signs. The afore-detailed description for the exemplary embodiment of FIG. 9 may be applied to the system 100 of FIG. 10, except for the hereinafter-mentioned differences.

The system 100 of FIG. 10 further comprises the stage region 118 configured to receive the crystalline structure 102, and the stage controller 120 configured to continuously change a position of the state region 118. Thereby, a surface of the crystalline structure 102 is scanned by the optical device 112. The surface of the crystalline structure 102 may comprise, for example, a surface facing the optical device 112, as disclosed above.

The stage region 118 may be a nanopositioning stage region with nanometer precision so that, once the spectrum of one of the defect color centers 114 is detected by the optical device 112, the crystalline structure 112 is moved by means of the stage controller 120 and the state region 118, and another defect color center 104 can be targeted by the optical device 112 leading to the analysis of another region of the crystalline structure 102.

Thereby, the stage region 118 and the stage controller 120 enable to automatically and continuously move the crystalline structure 102 so that the optical device 112 may scan a surface of the crystalline structure 102.

The system 100 according to the exemplary embodiments of FIG. 4A-B and 8 to 10 may be further configured to authenticate the crystalline structure 102 based on the generated unique tag 116, in a similar manner as QR codes or barcodes are currently used to identify objects.

To that end, the processor 114 (or a different one) may be further configured to store a reference tag for a crystalline structure. Alternatively, the reference tag for the crystalline structure may be stored in an authentication database. The authentication database may be an online database, and the processor 114 may be configured to access the online authentication database.

The reference tag may comprise at least information comprised in the atomic signature from which a tag has been generated.

Upon generating the unique tag 116 for the crystalline structure 102 based on the optical response of the crystalline structure 102 (and therefore on information of the local non-zero spin atomic distribution corresponding to at least one defect color center 104), in the manner disclosed above, the processor 114 (or a different processor) may be further configured to determine a tag difference based on the generated unique tag 116 for the crystalline structure 102 and the reference tag. Further, the processor 114 (or a different processor) may be configured to determine that the crystalline structure 102 is authentic when the tag difference is less than a preset threshold.

Thereby, the system 100 according to the embodiments of this disclosure may exploit the quantum states of the local non-zero spin atomic distribution 106 corresponding to each of the defect color centers 104 present in the crystalline structure 102 to generate a respective unique tag 116 and to further employ the tag 116 it in order to authenticate the crystalline structure 102, additionally or alternatively an object associated with the crystalline structure 102 and to which the unique tag may be attached.

The system 100 according to the exemplary embodiments of FIG. 4A-B and 8 to 10 may be further configured to identify the crystalline structure 102 based on the generated unique tag 116. For example, the processor 114 (or a different one) may be configured to store a lookup table comprising a plurality of tags and a corresponding identifier. Each of the tags may be associated with a respective crystalline structure, and each identifier comprises information of the respective crystalline structure. Alternatively, the lookup table may be stored in an online identification database, and the processor 114 may be configured to access the online identification database.

Each of the plurality of tags in the lookup table may comprise at least information comprised in the atomic signature from which a tag has been generated.

Then, the processor 114 (or a different one) may be further configured to search for the generated unique tag 116 for the crystalline structure 102 in the lookup table. When the generated unique tag 116 matches one of the tags in the lookup table, the processor may be configured to identify the crystalline structure 102 as valid.

Thereby, the system 100 according to the embodiments of this disclosure may exploit the local non-zero spin atomic distribution of the one or more defect color centers 104 comprised in the crystalline structure 102 to generate a unique tag 116 and to further employ the unique tag 116 it in order to identify the crystalline structure, additionally or alternatively or an object associated with the crystalline structure and to which the unique tag may be attached.

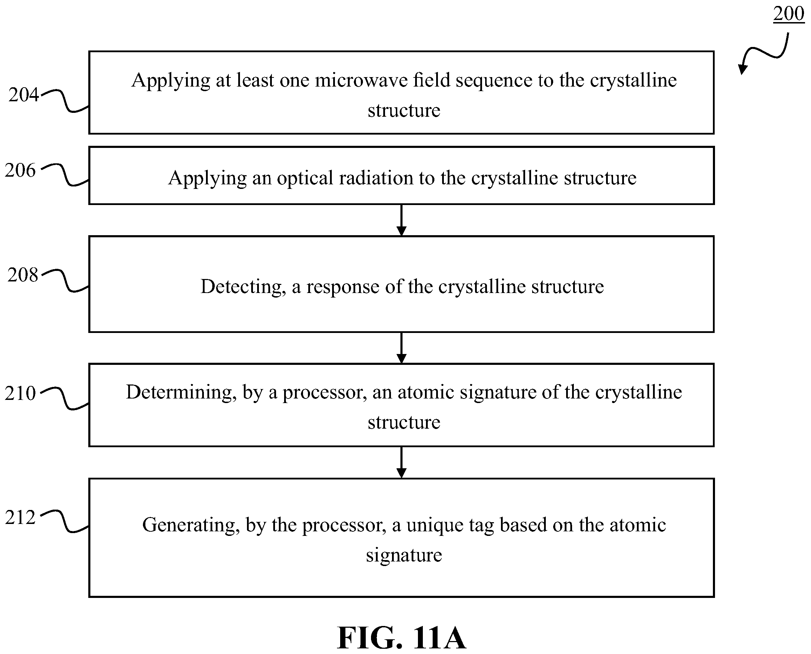

FIG. 11A shows an exemplary embodiment for a method 200 for generating a tag from a crystalline structure 102 comprising at least one defect color center 104 and a plurality of non-zero spin nuclei in the vicinity of each defect color center 104, according to this disclosure. The method 200 may be performed by the system 100 as disclosed above. Analyzing the structure 102 permits to determine an atomic signature thereof, as well as generating, from the determined atomic signature, a unique tag for the structure 102.

The method 200 comprises a step 204 of applying at least one microwave field sequence 110 to the crystalline structure 102. The microwave field sequence 110 can be applied by a microwave source 120.

The method 200 also comprises a step 206 of applying optical radiation to the crystalline structure 102 to excite at least one defect color center. The optical radiation is for example applied by a light source, such as a laser source.

Then, the method 200 comprises a step 208 of detecting, for at least one defect color center 104 and at least one nucleus of the plurality of non-zero spin nuclei located in the vicinity thereof, a response of the crystalline structure 102 to the applied MW radiation and optical excitation. This can be done at several positions, referring to the ability to detect a response associated to single defect color centers of the structure 102. The response can be an optical response or a photoelectric response. When it is an optical response, it is carried out by an optical device 112.

Further, the method 200 comprises a step 210 of determining, from the detected response, by a processor 114, an atomic signature of the crystalline structure 102. The atomic signature comprises information of the at least one non-zero spin nucleus of the at least one defect color center 104. This information can be at least one property of a local non-zero spin atomic distribution related to each of the defect color centers 104.

In a further step 212, the method 200 comprises generating, by the processor 114, a unique tag 116 based on the atomic signature.

The steps 204 and 206 are typically applied one after the other. The order of these steps is typically as follows: An optical radiation is applied to initialize the defect color sensor (which will act as a sensor). Then the MW field sequence is applied. Finally optical radiation is applied to read the response.

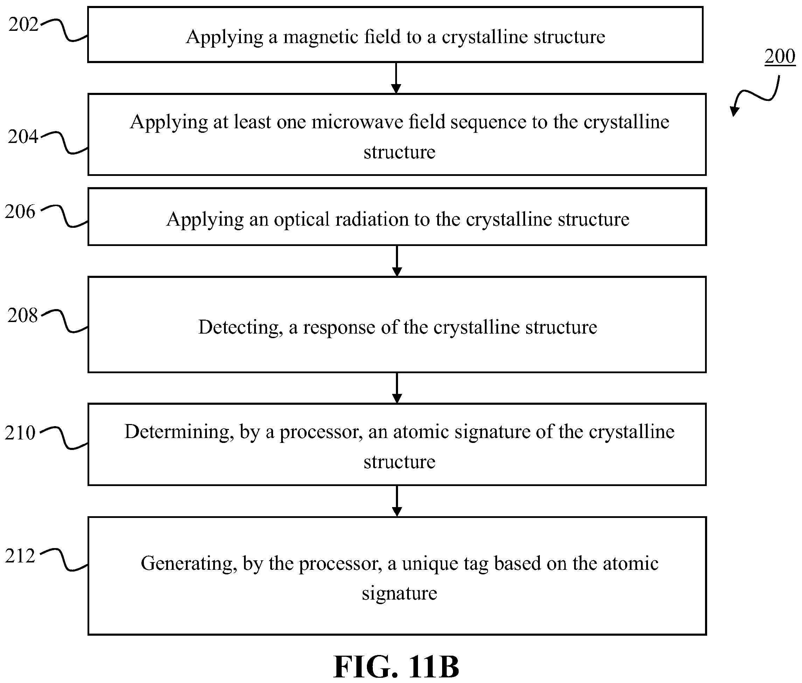

Optionally, in circumstances in which it may be needed, the method 200 can comprise a step 202 of applying a magnetic field to the crystalline structure 102. The magnetic field can for example be applied by a magnet. This particular method is shown in FIG. 11B. In this embodiment, the detection step 208 is in response to the MW radiation, to the optical excitation and to the applied magnetic field. In this case, under the influence of the applied magnetic field, typically an optical radiation is applied to initialize the defect color sensor (which will act as a sensor). Then the MW field sequence is applied. Finally optical radiation is applied to read the response.

The method 200 can be further developed according to the disclosed implementations of the system 100. The method 200 thus achieves the same advantages as the system 100. This disclosure further provides a computer program product comprising a program code for carrying out, when implemented on a processor, the method 200 shown in FIG. 11A or 11B. The computer program code may be included in a computer readable medium of the computer program product.

The computer readable medium may comprise essentially any memory, such as a ROM (Read-Only Memory), a PROM (Programmable Read-Only Memory), a EPROM (Erasable PROM), a Flash memory, an EEPROM (Electrically Erasable PROM), or a hard disk drive.

The computer program product may further comprise actions according to the described aforementioned method 200. Hence, the computer program product achieves the same advantages that the method 200 and as the system 100.

Further, this disclosure provides the use of a unique tag 116 for a crystalline structure 102 generated according to the method 200 in digital tracking and transactions registry or database applications. The digital tracking and transactions registry or database may comprise, for example but not as a limitation, a blockchain application.

The term blockchain refers to any system for recording digital transactions and events that is managed in a consensual and distributed manner in computer networks consisting of nodes. The record of digital transactions and events is replicated in several nodes and receives characteristics of immutability, determinism and non-repudiation. The state of a corresponding log is shared by the nodes participating in the network.

Participation, as a node, in network administration can be open or restricted to privileged entities. Access as a user to registry information may be universal (public) or may be restricted to privileged users, e.g., through public key infrastructure (PKI) systems.

An origin of the information, or issuance of a transaction, is guaranteed invariably, as each transaction is signed at the origin. Depending on the blockchain solution used, the user can be identified by a digital certificate or a public key that pseudonymizes them.

According to this disclosure, the digital certificate or the public key may be based on the unique tag 116 for the crystalline structure 102 generated by the system 100 according to the method 200, as disclosed above. The crystalline structure 102 may be assigned to the user in a blockchain solution. Thereby, a blockchain application may be performed based on the optical response of the crystalline structure 102.

The blockchain according to this disclosure may comprise: a user configured to register the unique tag 116, a first application, configured to contain a functionality and an operation of the process, and a second application, the second application being registered in a network for management of a digital tag. The digital tag may comprise an identifier associated with the unique tag 116.

The first application may comprise a mobile application or a web application. The second application may comprise a smart contract.

The blockchain may be configured to perform preliminary actions and process actions. The preliminary actions may comprise programming a predefined structure and behavior for the digital tag in the smart contract. Further, the preliminary actions may comprise installing the smart contract in a blockchain network.

The smart contract may be configured to manage the digital tag. The management of the digital tag may comprise registration of the digital tag, transfer of the digital tag, additionally or alternatively deletion of the digital tag.

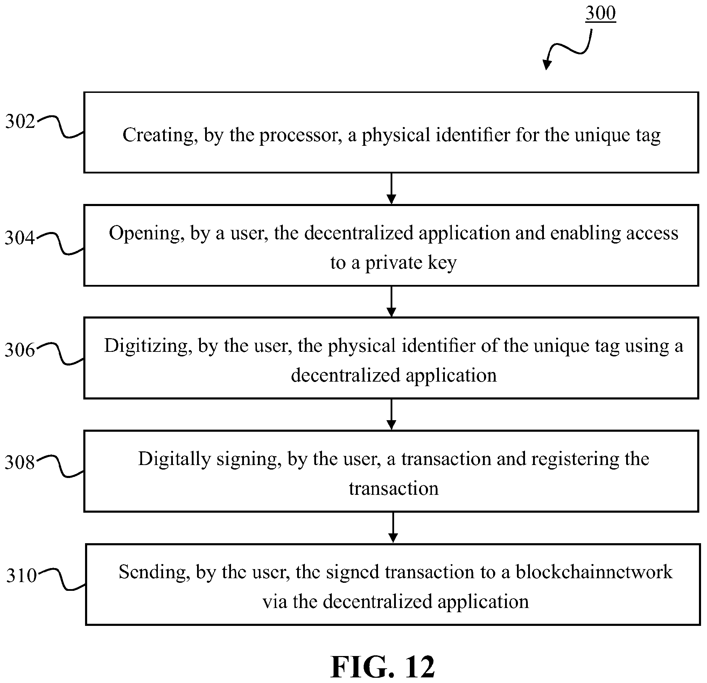

FIG. 12 shows a flowchart of a method 300 for using the unique tag 116 according to this disclosure. In particular, the method 300 comprises the process actions of the blockchain. In a step 302, a physical identifier for the unique tag 116 may be created. Then, in step 304, the user may open a decentralized application and may enable access to the private key. In step 306, the user may digitize the physical identifier of the unique tag 116 through the decentralized application. Next, in step 308, the user may digitally sign a transaction and may subsequently register the digital tag. Further, the user may send 310 the signed transaction to the blockchain network via the decentralized application.

Further, the blockchain network may receive the signed transaction and may further include it in a network record. Once the transaction is included in the network record, the user has an immutable stamp of the transaction.

The system 100 according to embodiments of this disclosure may be further configured to use the unique tag 116 for a crystalline structure 102, generated according to the method 200, in the blockchain application as disclosed above. In particular, the processor 114 may be configured to communicate with the blockchain network and with a production device. The production device may be accessible by the user.

Then, the processor 114 may be further configured to perform the step 302 according to the method 300. Further, the processor may be configured to enable the user to perform, by using the production device, the steps 304 to 310.

The blockchain application according to this disclosure exploits the uniqueness of the tag 116 so that meta-information of the unique tag 116 can be digitally linked to an identifier and a user. Further, the user can make a direct registration statement about the digital tag with a timestamp, the timestamp indicating the tag identifier and other necessary meta-information of the tag. Then, a smart contract installed on the blockchain network may allow the user to perform the actions of registration, transfer, and deletion of the digital tag.

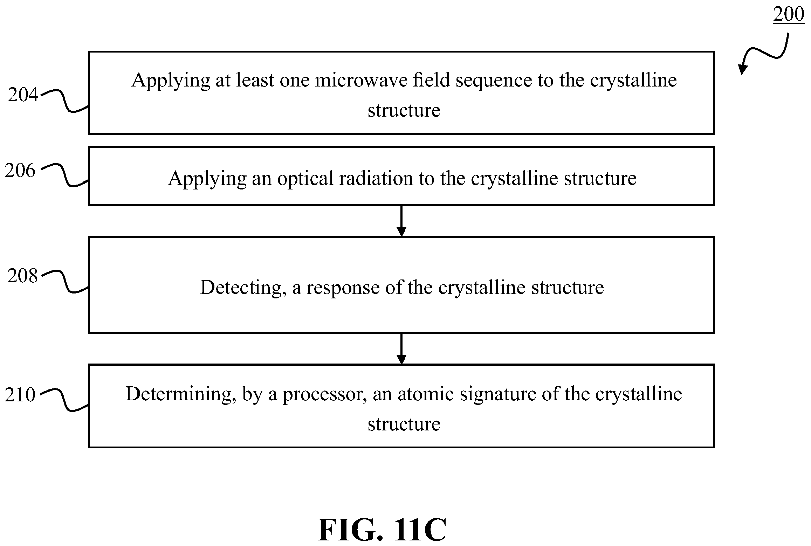

FIG. 11C shows an exemplary embodiment for a method 200 for determining an atomic signature of a crystalline structure 102 comprising at least one defect color center 104 and a plurality of non-zero spin nuclei in the vicinity of each defect color center 104, according to this disclosure. The method 200 may be performed by the system 100 as disclosed above. Analyzing the structure 102 permits to determine an atomic signature thereof.

The method 200 comprises a step 204 of applying at least one microwave field sequence 110 to the crystalline structure 102. The microwave field sequence 110 can be applied by a microwave source 120.

The method 200 also comprises a step 206 of applying optical radiation to the crystalline structure 102 to excite at least one defect color center. The optical radiation is for example applied by a light source, such as a laser source.

Then, the method 200 comprises a step 208 of detecting, for at least one defect color center 104 and at least one nucleus of the plurality of non-zero spin nuclei located in the vicinity thereof, a response of the crystalline structure 102 to the applied MW radiation and optical excitation. This can be done at several positions, referring to the ability to detect a response associated to single defect color centers of the structure 102. The response can be an optical response or a photoelectric response. When it is an optical response, it is carried out by an optical device 112.

Further, the method 200 comprises a step 210 of determining, from the detected response, by a processor 114, an atomic signature of the crystalline structure 102. The atomic signature comprises information of the at least one non-zero spin nucleus of the at least one defect color center 104. This information can be at least one property of a local non-zero spin atomic distribution related to each of the defect color centers 104.

Optionally, in circumstances in which it may be needed, the method 200 can comprise a step 202 of applying a magnetic field to the crystalline structure 102, in a similar manner as shown in FIG. 11B.

The method 200 can be further developed according to the disclosed implementations of the system 100. The method 200 thus achieves the same advantages as the system 100. This disclosure further provides a computer program product comprising a program code for carrying out, when implemented on a processor, the method 200 shown in FIG. 11C. The computer program code may be included in a computer readable medium of the computer program product.

The computer readable medium may comprise essentially any memory, such as a ROM (Read-Only Memory), a PROM (Programmable Read-Only Memory), a EPROM (Erasable PROM), a Flash memory, an EEPROM (Electrically Erasable PROM), or a hard disk drive.

The computer program product may further comprise actions according to the described aforementioned method 200. Hence, the computer program product achieves the same advantages that the method 200 and as the system 100.

Further, this disclosure provides the use of the atomic signature determined according to the method, to implement quantum devices, such as a quantum memory or a quantum computer.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A method (200) for generating a tag from a crystalline structure (102) comprising at least one defect color center (104) and a plurality of non-zero spin nuclei (106) in the vicinity of each defect color center (104), the method comprising:
applying (204) at least one microwave field sequence to the crystalline structure (102);
applying (206) an optical radiation to the crystalline structure (102) to excite at least one defect color center;
detecting (208), for at least one defect color center (104) and at least one nucleus of the plurality of non-zero spin nuclei (106) located in the vicinity thereof, a response of the crystalline structure (102);
the method being **characterized in**:
from the detected response, determining (210), by a processor (114), an atomic signature of the crystalline structure (102), said atomic signature comprising information of the non-zero spin nuclei distribution of the at least one defect color center (104), wherein said information is the relative position XYZ of the at least one non-zero spin nucleus with respect to the corresponding defect color center (104);
generating (212), by the processor (114), a unique tag based on the atomic signature.

2. The method (100) according to claim 1, wherein the response of the crystalline structure (102) is an optical response, and the optical response preferably comprises a photoluminescence spectrum emitted by each of the defect color centers (104), wherein the optical response depends on at least one property of the non-zero spin atomic distribution (106) corresponding to each of the defect color centers (104).

3. The method according to any one of claims 1-2, wherein the information of the at least one non-zero spin nucleus in the vicinity of the at least one defect color center comprised in the atomic signature is extracted from the detected response using an artificial intelligence (AI) model.

4. The method according to any one of claims 1 to 3, wherein the at least one microwave field sequence (110) comprises a plurality of microwave field sequences (100), and each of the plurality of microwave field sequences (110) are respectively different from each other.

5. A system (100) for generating a tag from a crystalline structure (102) comprising at least one defect color center (104) and a plurality of non-zero spin nuclei (106) in the vicinity of each defect color center (104), the system (100) comprising:
a microwave source (108) configured to apply at least one microwave field sequence (110) to the crystalline structure (102);
a light source (113) configured to apply an optical radiation to the crystalline structure (102) to excite at least one defect color center;
a device (112) configured to detect, for at least one defect color center (104) and at least one nucleus of the plurality of non-zero spin nuclei (106) located in the vicinity thereof, a response of the crystalline structure (102); and
a processor (114);
the system (100) being **characterized in that** the processor (114) is configured to:
from the detected response, determine an atomic signature of the crystalline structure (102), said atomic signature comprising information of the non-zero spin nuclei distribution of the at least one defect color center (104), wherein said information is the relative position XYZ of the at least one non-zero spin nucleus with respect to the corresponding defect color center (104);
generate a unique tag based on the atomic signature.

6. The system (100) according to claim 5, wherein the device (112) is configured to detect, for at least one defect color center (104) and at least one nucleus of the plurality of non-zero spin nuclei (106) located in the vicinity thereof, a response of the crystalline structure (102), is an optical detection device.

7. The system (100) according to any one of claims 5-6, further comprising:
a stage region (118) configured to receive the crystalline structure (102); and
a stage controller (120) configured to continuously change a position of the state region (118), so that a surface of the crystalline structure (102) is scanned by the device (112).

8. The system (100) according to any one of claims 5 to 7, wherein the system (100) further comprises a radiofrequency, RF, controller (122) configured to apply at least one RF field (124) to the crystalline structure (102).

9. The system (100) according to claim 8, wherein the device (112) is further configured to detect, at several positions, the response of the crystalline structure (102) to the at least one microwave field sequence (110) and to the applied at least one RF field (124).

10. The system (100) according to any one of claims 5 to 9, wherein a processor is further configured to authenticate the crystalline structure (102) based on the generated unique tag (116).

11. The system (100) according to claim 10, wherein a processor (114) is further configured to:
determine a tag difference based on the generated unique tag (116) and a reference tag associated to the crystalline structure (102); and
determine that the crystalline structure (102) is authentic when the tag difference exceeds a preset threshold.

12. A computer program product comprising a program code for carrying out, when implemented on a processor, the following from a response of a crystalline structure (102) detected, for at least one defect color center (104) and at least one nucleus of the plurality of non-zero spin nuclei (106) located in the vicinity thereof, after applying at least one microwave field sequence to a crystalline structure (102) and an optical radiation to the crystalline structure (102) to excite at least one defect color center:
determine an atomic signature of the crystalline structure (102), said atomic signature comprising information of the non-zero spin nuclei distribution of the at least one defect color center (104), wherein said information is the relative position XYZ of the at least one non-zero spin nucleus with respect to the corresponding defect color center (104); and
generate a unique tag based on the atomic signature.

13. The use of a unique tag (116) associated to a crystalline structure (102) generated according to the method of any one of claims 1-4 in an application involving digital identification, authentication, tracking and transactions registry or database, the application involving digital identification, authentication, tracking and transactions registry or database preferably comprising a blockchain application.

## Patentansprüche

1. Verfahren (200) zum Erzeugen eines Etiketts aus einer kristallinen Struktur (102), die mindestens einen Farbzentrum-Defekt (104) und eine Vielzahl von Kernen mit einem Spin ungleich null (106) in der Nähe von jedem Farbzentrum-Defekt (104) umfasst, wobei das Verfahren Folgendes umfasst:
Anlegen (204) von mindestens einer Mikrowellenfeld-Sequenz an die kristalline Struktur (102);
Bestrahlen (206) der kristallinen Struktur (102) mit einer optischen Strahlung und dadurch Anregen von mindestens einem Farbzentrum-Defekt;
Erfassen (208), für mindestens einen Farbzentrum-Defekt (104) und mindestens einen Kern von der Vielzahl von Kernen mit einem Spin ungleich null (106), die sich in dessen Nähe befinden, einer Reaktion der kristallinen Struktur (102);
wobei das Verfahren **gekennzeichnet ist durch**:
aus der erfassten Reaktion Bestimmen (210), mit einem Prozessor (114), einer atomaren Signatur der kristallinen Struktur (102), wobei die atomare Signatur Informationen zur Verteilung der Kerne mit einem Spin ungleich null bei dem mindestens einen Farbzentrum-Defekt (104) umfasst, wobei die Informationen die relative Lage XYZ des mindestens einen Kerns mit einem Spin ungleich null bezogen auf den entsprechenden Farbzentrum-Defekt (104) sind;
Erzeugen (212), mit dem Prozessor (114), eines einzigartigen Etiketts auf Grundlage der atomaren Signatur.

2. Verfahren (100) nach Anspruch 1, wobei die Reaktion der kristallinen Struktur (102) eine optische Reaktion ist und die optische Reaktion vorzugsweise ein Photolumineszenzspektrum umfasst, das von jedem der Farbzentrum- Defekte (104) emittiert wird, wobei die optische Reaktion von mindestens einer Eigenschaft der Verteilung von Atomen mit einem Spin ungleich null (106) abhängt, die jedem der Farbzentrum-Defekte (104) entspricht.

3. Verfahren nach einem der Ansprüche 1 bis 2, wobei die Informationen zu dem mindestens einen Kern mit einem Spin ungleich null in der Nähe des mindestens einen Farbzentrum-Defekts, die in der atomaren Signatur enthalten sind, unter Verwendung eines Modells der künstlichen Intelligenz (KI) aus der erfassten Reaktion gewonnen werden.

4. Verfahren nach einem der Ansprüche 1 bis 3, wobei die mindestens eine Mikrowellenfeld-Sequenz (110) eine Vielzahl von Mikrowellenfeld-Sequenzen (100) umfasst und sich alle von der Vielzahl von Mikrowellenfeld-Sequenzen (110) jeweils voneinander unterscheiden.

5. System (100) zum Erzeugen eines Etiketts aus einer kristallinen Struktur (102), die mindestens ein Farbzentrum-Defekt (104) und eine Vielzahl von Kernen mit einem Spin ungleich null (106) in der Nähe von jedem Farbzentrum-Defekt (104) umfasst, wobei das System (100) Folgendes umfasst:
eine Mikrowellenquelle (108), die so ausgelegt ist, dass sie mindestens eine Mikrowellenfeld-Sequenz (110) an die kristalline Struktur (102) anlegt;
eine Lichtquelle (113), die so ausgelegt ist, dass sie die kristalline Struktur (102) mit einer optischen Strahlung bestrahlt und dadurch mindestens einen Farbzentrum-Defekt anregt;
eine Vorrichtung (112), die so ausgelegt ist, dass sie, für mindestens einen Farbzentrum-Defekt (104) und mindestens einen Kern von der Vielzahl von Kernen mit einem Spin ungleich null (106), die sich in dessen Nähe befinden, eine Reaktion der kristallinen Struktur (102) erfasst; sowie
einen Prozessor (114);
wobei das System (100) **dadurch gekennzeichnet ist, dass** der Prozessor (114) so ausgelegt ist, dass er:
aus der erfassten Reaktion eine atomare Signatur der kristallinen Struktur (102) bestimmt, wobei die atomare Signatur Informationen zur Verteilung der Kerne mit einem Spin ungleich null bei dem mindestens einen Farbzentrum-Defekt (104) umfasst, wobei die Informationen die relative Lage XYZ des mindestens einen Kerns mit einem Spin ungleich null bezogen auf den entsprechenden Farbzentrum-Defekt (104) sind;
auf Grundlage der atomaren Signatur ein einzigartiges Etikett erzeugt.

6. System (100) nach Anspruch 5, wobei die Vorrichtung (112), die so ausgelegt ist, dass sie für mindestens einen Farbzentrum-Defekt (104) und mindestens einen Kern von der Vielzahl von Kernen mit einem Spin ungleich null (106), die sich in dessen Nähe befinden, eine Reaktion der kristallinen Struktur (102) erfasst, eine optische Detektionsvorrichtung ist.

7. System (100) nach einem der Ansprüche 5 bis 6, ferner umfassend:
einen Tischbereich (118), der so ausgelegt ist, dass er die kristalline Struktur (102) aufnimmt; und
eine Tischsteuerung (120), die so ausgelegt ist, dass sie kontinuierlich eine Position des Zustandsbereichs (118) ändert, sodass eine Oberfläche der kristallinen Struktur (102) von der Vorrichtung (112) abgetastet wird.

8. System (100) nach einem der Ansprüche 5 bis 7, wobei das System (100) ferner eine Hochfrequenzsteuerung, HF-Steuerung (122) umfasst, die so ausgelegt ist, dass sie an die kristalline Struktur (102) mindestens ein HF-Feld (124) anlegt.

9. System (100) nach Anspruch 8, wobei die Vorrichtung (112) ferner so ausgelegt ist, dass sie an mehreren Positionen die Reaktion der kristallinen Struktur (102) auf die mindestens eine Mikrowellenfeld-Sequenz (110) und auf das angelegte mindestens eine HF-Feld (124) erfasst.

10. System (100) nach einem der Ansprüche 5 bis 9, wobei ein Prozessor ferner so ausgelegt ist, dass er die kristalline Struktur (102) auf Grundlage des erzeugten einzigartigen Etiketts (116) authentifiziert.

11. System (100) nach Anspruch 10, wobei ein Prozessor (114) ferner so ausgelegt ist, dass er:
auf Grundlage des erzeugten einzigartigen Etiketts (116) und eines Referenzetiketts, das der kristallinen Struktur (102) zugehörig ist, einen Etikettenunterschied feststellt; und
feststellt, dass die kristalline Struktur (102) authentisch ist, wenn der Etikettenunterschied eine vorher festgelegte Schwelle überschreitet.

12. Computerprogrammprodukt, das einen Programmcode umfasst, mit dem, wenn er auf einem Prozessor ausgeführt wird, aus einer Reaktion einer kristallinen Struktur (102), die, für mindestens einen Farbzentrum-Defekt (104) und mindestens einen Kern von der Vielzahl von Kernen mit einem Spin ungleich null (106), die sich in dessen Nähe befinden, nach dem Anlegen von mindestens einer Mikrowellenfeld-Sequenz an eine kristalline Struktur (102) und dem Bestrahlen der kristallinen Struktur (102) mit einer optischen Strahlung und dadurch Anregen mindestens eines Farbzentrum-Defekts, erfasst wird, Folgendes durchgeführt wird:
Bestimmen einer atomaren Signatur der kristallinen Struktur (102), wobei die atomare Signatur Informationen zur Verteilung der Kerne mit einem Spin ungleich null bei dem mindestens einen Farbzentrum-Defekt (104) umfasst, wobei die Informationen die relative Lage XYZ des mindestens einen Kerns mit einem Spin ungleich null bezogen auf den entsprechenden Farbzentrum-Defekt (104) sind; und
Erzeugen eines einzigartigen Etiketts auf Grundlage der atomaren Signatur.

13. Verwendung eines einzigartigen Etiketts (116), das einer kristallinen Struktur (102) zugehörig ist und gemäß dem Verfahren nach einem der Ansprüche 1 bis 4 erzeugt wird, in einer Anwendung, die digitale Identifizierung, Authentifizierung, Nachverfolgung und Transaktionsregistrierung oder Datenbanken umfasst, wobei die Anwendung, die digitale Identifizierung, Authentifizierung, Nachverfolgung und Transaktionsregistrierung oder Datenbanken umfasst, vorzugsweise eine Blockchain-Anwendung umfasst.

## Revendications

1. Procédé (200) pour générer une étiquette à partir d'une structure cristalline (102) comprenant au moins un centre coloré de défaut (104) et une pluralité de noyaux à spin non nul (106) à proximité de chaque centre coloré de défaut (104), le procédé comprenant :
l'application (204) d'au moins une séquence de champs de micro-ondes à la structure cristalline (102) ;
l'application (206) d'un rayonnement optique à la structure cristalline (102) pour exciter au moins un centre coloré de défaut ;
la détection (208), pour au moins un centre coloré de défaut (104) et au moins un noyau de la pluralité de noyaux à spin non nul (106) situés à proximité de celui-ci, d'une réponse de la structure cristalline (102) ;
le procédé étant **caractérisé par** :
à partir de la réponse détectée, la détermination (210), par un processeur (114), d'une signature atomique de la structure cristalline (102), ladite signature atomique comprenant des informations de la distribution de noyaux à spin non nul de l'au moins un centre coloré de défaut (104), où lesdites informations sont la position relative XYZ de l'au moins un noyau à spin non nul par rapport au centre coloré de défaut correspondant (104) ;
la génération (212), par le processeur (114), d'une étiquette unique sur la base de la signature atomique.

2. Procédé (100) selon la revendication 1, dans lequel la réponse de la structure cristalline (102) est une réponse optique, et la réponse optique comprend de préférence un spectre de photoluminescence émis par chacun des centres colorés de défaut (104), où la réponse optique dépend d'au moins une propriété de la distribution atomique à spin non nul (106) correspondant à chacun des centres colorés de défaut (104).

3. Procédé selon l'une quelconque des revendications 1 et 2, dans lequel les informations de l'au moins un noyau à spin non nul à proximité de l'au moins un centre coloré de défaut compris dans la signature atomique sont extraites de la réponse détectée en utilisant un modèle d'intelligence artificielle (IA).

4. Procédé selon l'une quelconque des revendications 1 à 3, dans lequel l'au moins une séquence de champs de micro-ondes (110) comprend une pluralité de séquences de champs de micro-ondes (100), et chacune de la pluralité de séquences de champs de micro-ondes (110) est respectivement différente des autres.

5. Système (100) pour générer une étiquette à partir d'une structure cristalline (102) comprenant au moins un centre coloré de défaut (104) et une pluralité de noyaux à spin non nul (106) à proximité de chaque centre coloré de défaut (104), le système (100) comprenant :
une source de micro-ondes (108) configurée pour appliquer au moins une séquence de champs de micro-ondes (110) à la structure cristalline (102) ;
une source de lumière (113) configurée pour appliquer un rayonnement optique à la structure cristalline (102) pour exciter au moins un centre coloré de défaut ;
un dispositif (112) configuré pour détecter, pour au moins un centre coloré de défaut (104) et au moins un noyau de la pluralité de noyaux à spin non nul (106) situés à proximité de celui-ci, une réponse de la structure cristalline (102) ; et
un processeur (114) ;
le système (100) étant **caractérisé en ce que** le processeur (114) est configuré pour :
à partir de la réponse détectée, déterminer une signature atomique de la structure cristalline (102), ladite signature atomique comprenant des informations de la distribution de noyaux à spin non nul de l'au moins un centre coloré de défaut (104), où lesdites informations sont la position relative XYZ de l'au moins un noyau à spin non nul par rapport au centre coloré de défaut correspondant (104) ;
générer une étiquette unique sur la base de la signature atomique.

6. Système (100) selon la revendication 5, dans lequel le dispositif (112) configuré pour détecter, pour au moins un centre coloré de défaut (104) et au moins un noyau de la pluralité de noyaux à spin non nul (106) situés à proximité de celui-ci, une réponse de la structure cristalline (102), est un dispositif de détection optique.

7. Système (100) selon l'une quelconque des revendications 5 et 6, comprenant en outre :
une région de platine (118) configurée pour recevoir la structure cristalline (102) ; et
un dispositif de commande de platine (120) configuré pour modifier en continu la position de la région de platine (118), de sorte qu'une surface de la structure cristalline (102) soit balayée par le dispositif (112).

8. Système (100) selon l'une quelconque des revendications 5 à 7, dans lequel le système (100) comprend en outre un dispositif de commande (122) de radiofréquence, RF, configuré pour appliquer au moins un champ RF (124) à la structure cristalline (102).

9. Système (100) selon la revendication 8, dans lequel le dispositif (112) est en outre configuré pour détecter, en plusieurs positions, la réponse de la structure cristalline (102) à l'au moins une séquence de champs de micro-ondes (110) et à l'au moins un champ RF (124) appliqué.

10. Système (100) selon l'une quelconque des revendications 5 à 9, dans lequel un processeur est en outre configuré pour authentifier la structure cristalline (102) sur la base de l'étiquette unique générée (116).

11. Système (100) selon la revendication 10, dans lequel un processeur (114) est en outre configuré pour :
déterminer une différence d'étiquette sur la base de l'étiquette unique générée (116) et d'une étiquette de référence associée à la structure cristalline (102) ; et
déterminer que la structure cristalline (102) est authentique lorsque la différence d'étiquette dépasse un seuil prédéfini.

12. Produit de programme informatique comprenant un code de programme pour réaliser, lorsqu'il est mis en œuvre sur un processeur, ce qui suit à partir d'une réponse d'une structure cristalline (102) détectée, pour au moins un centre coloré de défaut (104) et au moins un noyau de la pluralité de noyaux à spin non nul (106) situés à proximité de celui-ci, après l'application d'au moins une séquence de champs de micro-ondes à une structure cristalline (102) et d'un rayonnement optique à la structure cristalline (102) pour exciter au moins un centre coloré de défaut :
la détermination d'une signature atomique de la structure cristalline (102), ladite signature atomique comprenant des informations de la distribution de noyaux à spin non nul de l'au moins un centre coloré de défaut (104), où lesdites informations sont la position relative XYZ de l'au moins un noyau à spin non nul par rapport au centre coloré de défaut correspondant (104) ; et
la génération d'une étiquette unique sur la base de la signature atomique.

13. Utilisation d'une étiquette unique (116) associée à une structure cristalline (102) générée selon le procédé de l'une quelconque des revendications 1 à 4 dans une application impliquant l'identification numérique, l'authentification, le suivi et un registre ou une base de données de transactions, l'application impliquant l'identification numérique, l'authentification, le suivi et un registre ou une base de données de transactions comprenant de préférence une application de chaîne de blocs.
